# EUROPEAN PATENT APPLICATION

(11) **EP 4 797 542 A1**
(43) Date of publication of application: **26.08.2026**
(21) Application number: 24888080.9
(22) Date of filing: 08.11.2024
(51) Int. Cl.: H03M 13/11

(54) **COMMUNICATION METHOD AND DEVICE BASED ON LDPC CODE**

(30) Priority: 10.11.2023 CN 202311504043
(71) Applicant: HUAWEI TECHNOLOGIES CO., LTD., Shenzhen, Guangdong 518129 (CN)
(72) Inventor: LIU, Ke, Shenzhen, Guangdong 518129 (CN); ZHANG, Huazi, Shenzhen, Guangdong 518129 (CN); TONG, Jiajie, Shenzhen, Guangdong 518129 (CN); QIN, Kangjian, Shenzhen, Guangdong 518129 (CN); WANG, Xianbin, Shenzhen, Guangdong 518129 (CN); WANG, Jun, Shenzhen, Guangdong 518129 (CN)
(74) Representative: Thun, Clemens
(86) International application number: PCT/CN2024/130791
(87) International publication number: WO 2025/098469

(57) **Abstract**

An LDPC code-based communication method and a communication apparatus are provided. A region B in an LDPC base matrix used for encoding or decoding includes a first square matrix, the first square matrix includes at least two columns having column weights greater than or equal to 3 and/or at least one column having an even column weight greater than or equal to 4, and a row weight of each row in the first square matrix is greater than or equal to 2. In this way, a column weight of a column included in the first square matrix, namely, the region B, is not limited to 2 or 3, and may be a value other than 2 and 3. In addition, the first square matrix includes the at least two columns having column weights greater than or equal to 3 and/or the at least one column having an even column weight greater than or equal to 4, so that the first square matrix has a higher edge density. Therefore, in embodiments of this application, an encoding structure of the LDPC base matrix has a more flexible degree distribution and has a higher edge density. This helps implement fast convergence and improve encoding or decoding performance.

## Description

This application claims priority to Chinese Patent Application No. 202311504043.9, filed with the China National Intellectual Property Administration on November 10, 2023 and entitled "LDPC CODE-BASED COMMUNICATION METHOD AND COMMUNICATION APPARATUS", which is incorporated herein by reference in its entirety.

### TECHNICAL FIELD

This application relates to the coding field, and more specifically, to an LDPC code-based communication method and a communication apparatus.

### BACKGROUND

In the field of channel coding, low-density parity check (low-density parity check, LDPC) codes are among most mature and widely applied channel coding schemes. In current LDPC codes, an encoding structure of an LDPC base matrix imposes large limitations on a degree distribution, and the encoding structure exhibits a low edge density. This is not conducive to fast convergence, affecting encoding/decoding performance.

### SUMMARY

Embodiments of this application provide an LDPC code-based communication method and a communication apparatus, to help improve encoding or decoding performance.

According to a first aspect, an LDPC code-based communication method is provided. The method may be performed by a transmitter device, or may be performed by a module or a unit (for example, a chip) in a transmitter device. The transmitter device may be a terminal device or a network device.

The method includes: obtaining an information bit sequence; performing LDPC encoding on the information bit sequence based on an LDPC base matrix to obtain an LDPC codeword sequence, where a first matrix region in the LDPC base matrix includes a first square matrix, the first matrix region is formed by a 1^{st} row to a w^{th} row and an r^{th} column to an (r+w-1)^{th} column in the LDPC base matrix, the first square matrix includes at least two columns having column weights greater than or equal to 3 and/or at least one column having an even column weight greater than or equal to 4, a row weight of each row in the first square matrix is greater than or equal to 2, and w and r are positive integers; and outputting the LDPC codeword sequence.

In the foregoing method, a column weight of a column included in the first square matrix is not limited to 2 or 3, and may be a value other than 2 and 3. For example, the column weight may be greater than 2; or the column weight may be greater than 3; or the column weight may be an even number greater than or equal to 4. In this way, the encoding structure of the first square matrix has a more flexible degree distribution. In addition, the first square matrix includes the at least two columns having column weights greater than or equal to 3 and/or the at least one column having an even column weight greater than or equal to 4, so that the first square matrix has a larger weight or a higher edge density. Therefore, the encoding structure of the LDPC base matrix has a more flexible degree distribution, and the encoding structure has the larger weight or the higher edge density. This helps implement fast convergence and improve encoding or decoding performance.

According to a second aspect, an LDPC code-based communication method is provided. The method may be performed by a receiver device, or may be performed by a module or a unit (for example, a chip) in a receiver device. The receiver device may be a terminal device or a network device.

The method includes: obtaining an LDPC codeword sequence; and decoding the LDPC codeword sequence based on an LDPC base matrix to obtain an information bit sequence, where a first matrix region in the LDPC base matrix includes a first square matrix, the first matrix region is formed by a 1^{st} row to a w^{th} row and an r^{th} column to an (r+w-1)^{th} column in the LDPC base matrix, the first square matrix includes at least two columns having column weights greater than or equal to 3 and/or at least one column having an even column weight greater than or equal to 4, a row weight of each row in the first square matrix is greater than or equal to 2, and w and r are positive integers.

In the foregoing method, a column weight of a column included in the first square matrix is not limited to 2 or 3, and may be a value other than 2 and 3. For example, the column weight may be greater than 2; or the column weight may be greater than 3; or the column weight may be an even number greater than or equal to 4. In this way, an encoding structure of the first square matrix has a more flexible degree distribution. In addition, the first square matrix includes the at least two columns having column weights greater than or equal to 3 and/or the at least one column having an even column weight greater than or equal to 4, so that the first square matrix has a larger weight or a higher edge density. Therefore, the encoding structure of the LDPC base matrix has a more flexible degree distribution, and the encoding structure has the larger weight or the higher edge density. This helps implement fast convergence and improve encoding or decoding performance.

With reference to any one of the foregoing aspects, in some implementations, the first square matrix is an m×m matrix, where m is a positive integer. The first square matrix includes m-1 columns having even column weights and one column having an odd column weight, a row weight of each row in the first square matrix is 2 or 3, a quantity of rows having row weights being 3 in the first square matrix is 1 plus a quantity of the at least one column having an even column weight greater than or equal to 4. The m-1 columns having even column weights include the at least one column having an even column weight greater than or equal to 4.

In the foregoing implementation, the first square matrix includes the at least one column having an even column weight greater than or equal to 4, and the quantity of rows having row weights being 3 in the first square matrix is 1 plus the quantity of the at least one column having an even column weight greater than or equal to 4. Therefore, the first square matrix has the larger weight or the higher edge density. The encoding structure has an advantage of supporting a larger column degree, providing a better decoding threshold, and being easy to implement encoding.

With reference to any one of the foregoing aspects or the implementations, in some other implementations, the first square matrix includes one column having a column weight being 4, one column having a column weight being 3, and m-2 columns having column weights being 2.

With reference to any one of the foregoing aspects or the implementations, in some other implementations, m=4, and the first square matrix is: $\left[\begin{matrix}x & - 1 & a & c \\ y & - 1 & a & - 1 \\ x & z & b & - 1 \\ y & z & - 1 & c\end{matrix}\right] ,$ where
"-1" represents a zero element, "x", "y", "z", "a", "b", or "c" represents non-zero elements with respective shifting values of x, y, z, a, b, or c, x ≠ y, a≠ b, x, y, z, a, and c are positive integers, and b is a non-negative integer.

With reference to any one of the foregoing aspects or the implementations, in some other implementations, m=5, and the first square matrix is: $\left[\begin{matrix}x & d & c & - 1 & - 1 \\ x & - 1 & - 1 & p & a \\ y & - 1 & c & p & - 1 \\ y & d & - 1 & - 1 & - 1 \\ - 1 & b & - 1 & - 1 & a\end{matrix}\right] ,$ where
"-1" represents a zero element, "x", "y", "a", "b", "c", "d", or "p" represents non-zero elements with respective shifting values of x, y, a, b, c, d, or p, x ≠ y, b≠ d, x, y, a, p, c, and d are positive integers, and b is a non-negative integer.

With reference to any one of the foregoing aspects or the implementations, in some other implementations, the first square matrix includes two columns having column weights being 4, one column having a column weight being 3, and m-3 columns having column weights being 2.

With reference to any one of the foregoing aspects or the implementations, in some other implementations, m=5, and the first square matrix may be the following matrix: $\left[\begin{matrix}x & d & c & - 1 & - 1 \\ x & - 1 & - 1 & p & a \\ y & - 1 & c & p & e \\ y & d & - 1 & - 1 & a \\ - 1 & b & - 1 & - 1 & e\end{matrix}\right] ,$ where
"-1" represents a zero element, "x", "y", "a", "b", "c", "d", "e", or "p" represents non-zero elements with respective shifting values of x, y, a, b, c, d, e, or p, x ≠ y, b≠ d, a≠ e, x, y, a, p, c, d, and e are positive integers, and b is a non-negative integer.

With reference to any one of the foregoing aspects or the implementations, in some other implementations, a column weight of each column in the first square matrix is 2 or 3, and a quantity of columns having column weights being 2 in the first square matrix is greater than 0.

In the foregoing implementation, the first square matrix includes at least two columns having column weights greater than or equal to 3. Therefore, the first square matrix has the larger weight or the higher edge density, has a better decoding threshold, and is easy to implement encoding.

With reference to any one of the foregoing aspects or the implementations, in some other implementations, the quantity of columns having column weights being 2 in the first square matrix is an even number.

With reference to any one of the foregoing aspects or the implementations, in some other implementations, the first square matrix is an m×m matrix, where m is a positive integer. The first square matrix includes two columns having column weights being 2 and m-2 columns having column weights being 3.

With reference to any one of the foregoing aspects or the implementations, in some other implementations, the first square matrix is an m×m matrix, where m is an even number greater than 0. The first square matrix includes m-2 columns having column weights being 2 and two columns having column weights being 3.

With reference to any one of the foregoing aspects or the implementations, in some other implementations, m=4, and the first square matrix is any one of the following matrices: $\left[\begin{matrix}0 & 0 & 0 & - 1 \\ 0 & x & - 1 & 0 \\ 0 & - 1 & - 1 & x \\ - 1 & 0 & - x & - 1\end{matrix}\right] , \left[\begin{matrix}0 & 0 & 0 & - 1 \\ 0 & x & - 1 & 0 \\ 0 & - 1 & - 1 & - x \\ - 1 & 0 & x & - 1\end{matrix}\right] , \left[\begin{matrix}0 & 0 & 0 & - 1 \\ 0 & - 2 x & - 1 & 0 \\ 0 & - 1 & - 1 & x \\ - 1 & 0 & x & - 1\end{matrix}\right] , \left[\begin{matrix}0 & 0 & 0 & - 1 \\ 0 & - 1 & - 1 & 0 \\ 0 & - 1 & x & - x \\ - 1 & 0 & x & - 1\end{matrix}\right] ,$ $\left[\begin{matrix}0 & 0 & 0 & - 1 \\ 0 & - 1 & - 1 & 0 \\ 0 & - 1 & x & 2 x \\ - 1 & 0 & x & - 1\end{matrix}\right] , \left[\begin{matrix}0 & 0 & 0 & - 1 \\ 0 & - 1 & - 1 & 0 \\ 0 & - 1 & x & x \\ - 1 & 0 & - x & - 1\end{matrix}\right] , \left[\begin{matrix}0 & 0 & 0 & - 1 \\ 0 & - 1 & - 1 & 0 \\ 0 & - 1 & 2 x & x \\ - 1 & 0 & x & - 1\end{matrix}\right] , \left[\begin{matrix}0 & 0 & 0 & - 1 \\ 0 & x & - 1 & 0 \\ 0 & - 1 & x & - 1 \\ - 1 & 0 & - 1 & - x\end{matrix}\right] ,$ $\left[\begin{matrix}0 & 0 & 0 & - 1 \\ 0 & x & - 1 & 0 \\ 0 & - 1 & x & - 1 \\ - 1 & 0 & - 1 & - 2 x\end{matrix}\right] , or \left[\begin{matrix}0 & 0 & 0 & - 1 \\ 0 & x & - 1 & 0 \\ 0 & - 1 & - x & - 1 \\ - 1 & 0 & - 1 & 0\end{matrix}\right] ,$ where
"-1" represents a zero element, "0" represents a non-zero element with a shifting value of 0, "x" represents a non-zero element with a shifting value of x, "-x" represents a non-zero element with a shifting value of Z_{c}-x, "2x" represents a non-zero element with a shifting value of 2x, "-2x" represents a non-zero element with a shifting value of Z_{c}-2x, Z_{c} is a lifting size, and x is a positive integer.

With reference to any one of the foregoing aspects or the implementations, in some other implementations, the first square matrix is an m×m matrix, where m is an odd number greater than 0. The first square matrix includes m-3 columns having column weights being 2 and three columns having column weights being 3.

With reference to any one of the foregoing aspects or the implementations, in some other implementations, m=5, and the first square matrix is any one of the following matrices: $\left[\begin{matrix}0 & 0 & 0 & - 1 & - 1 \\ 0 & - 1 & - 1 & 0 & 0 \\ 0 & - 1 & z & - z & - 1 \\ - 1 & 0 & z & - 1 & - 1 \\ - 1 & 0 & - 1 & - 1 & x\end{matrix}\right] , \left[\begin{matrix}0 & 0 & 0 & - 1 & - 1 \\ 0 & - 1 & - 1 & 0 & 0 \\ 0 & - 1 & z & - z & - 1 \\ - 1 & 0 & z & - 1 & x \\ - 1 & 0 & - 1 & x & - 1\end{matrix}\right] , \left[\begin{matrix}0 & 0 & 0 & - 1 & - 1 \\ 0 & - 1 & - 1 & 0 & 0 \\ 0 & - 1 & - 1 & x & - 1 \\ - 1 & 0 & - 1 & 0 & - 1 \\ - 1 & 0 & x & - 1 & 0\end{matrix}\right] ,$ or $\left[\begin{matrix}0 & 0 & 0 & - 1 & - 1 \\ 0 & - 1 & - 1 & 0 & 0 \\ 0 & - 1 & x & - 1 & - 1 \\ - 1 & 0 & - 1 & 0 & x \\ - 1 & 0 & - 1 & - 1 & 0\end{matrix}\right] ,$ where
"-1" represents a zero element, "0" represents a non-zero element with a shifting value of 0, "x" represents a non-zero element with a shifting value of x, "-x" represents a non-zero element with a shifting value of Z_{c}-x, "z" represents a non-zero element with a shifting value of z, "-z" represents a non-zero element with a shifting value of Z_{c}-z, Z_{c} is a lifting size, and x and z are positive integers.

With reference to any one of the foregoing aspects or the implementations, in some other implementations, a column weight of each column and a row weight of each row in the first square matrix are both G, the first square matrix includes a first row and a second row, a quantity of elements in an intersection between a set of column numbers of columns in which non-zero elements in the first row are located and a set of column numbers of columns in which non-zero elements in the second row are located is 2, the first row and the second row are any two rows in the first square matrix, and G is greater than or equal to 3.

A degree distribution in the foregoing implementation helps a code distance of an LDPC code linearly increase with a code length, and helps construct a structure that is easy to implement coding.

With reference to any one of the foregoing aspects or the implementations, in some other implementations, G=3.

With reference to any one of the foregoing aspects or the implementations, in some other implementations, the first square matrix includes a first column and a second column, an intersection between a set of row numbers of rows in which non-zero elements in the first column are located and a set of row numbers of rows in which non-zero elements in the first column are located includes a maximum of one row number, and the first column and the second column are any two columns in the first square matrix. Row numbers of any two rows in the first square matrix belong to a set including row numbers of rows in which non-zero elements in a column in the first square matrix are located.

With reference to any one of the foregoing aspects or the implementations, in some other implementations, the first square matrix is an m×m matrix, where m is a positive integer. Non-zero elements in the first square matrix include first-type non-zero elements and second-type non-zero elements. Positions of the first-type non-zero elements include: a 1^{st} column to a 3^{rd} column in a 1^{st} row, a 4^{th} column and a 5^{th} column in a 2^{nd} row, ..., and a 2t^{th} column and a (2t+1)^{th} column in a t^{th} row in the first square matrix, and a 1^{st} row to a 3^{rd} row in a 1^{st} column, a 4^{th} row and a 5^{th} row in a 2^{nd} column, ..., and a 2t^{th} row and a (2t+1)^{th} row in a t^{th} column in the first square matrix, where t is greater than or equal to 2. The second-type non-zero elements are located in a first sub-region in the first square matrix, and the first sub-region is defined by an ${\left(m-\left⌈\frac{m}{2}\right⌉+1\right)}^{th}$ row to an m^{th} row and an ${\left(m-\left⌈\frac{m}{2}\right⌉+1\right)}^{th}$ column to an m^{th} column in the first matrix region.

With reference to any one of the foregoing aspects or the implementations, in some other implementations, the positions of the second-type non-zero elements correspond to a first sequence and a second sequence, elements in the first sequence are the same as elements in $\left\{1,2,…,\left⌈\frac{m}{2}\right⌉-1,\left⌈\frac{m}{2}\right⌉\right\}$, elements in the second sequence are the same as elements in $\left\{1,2,…,\left⌈\frac{m}{2}\right⌉-1,\left⌈\frac{m}{2}\right⌉\right\}$ , an arrangement order of the elements in the first sequence is different from an arrangement order of the elements in the second sequence, and an i^{th} element pᵢ in the first sequence or the second sequence indicates that an element in an i^{th} row and a pᵢ^{th} column in the first sub-region is a non-zero element, where i is a positive integer less than or equal to $\left⌈\frac{m}{2}\right⌉$.

With reference to any one of the foregoing aspects or the implementations, in some other implementations, ${p}_{i} = \left(i+s\right) mod \left(\left⌈\frac{m}{2}\right⌉\right) + 1$, and s is a constant.

With reference to any one of the foregoing aspects or the implementations, in some other implementations, the first sequence and/or the second sequence are/is obtained based on a segmental cycle.

With reference to any one of the foregoing aspects or the implementations, in some other implementations, shifting values of the first-type non-zero elements are 0.

With reference to any one of the foregoing aspects or the implementations, in some other implementations, shifting values of the second-type non-zero elements are determined based on xi, x₂, ..., and xₜ, xi, x₂, ..., and xₜ are all greater than or equal to 0, and t is a positive integer.

With reference to any one of the foregoing aspects or the implementations, in some other implementations, t is equal to 1, and the shifting values of the second-type non-zero elements are k₁x₁; or t is equal to 2, and the shifting values of the second-type non-zero elements are k₁x₁, -k₁x₁, k₂x₂, -k₂x₂, or k₁x₁+k₂x₂; or t is greater than or equal to 3, and the shifting values of the second-type non-zero elements are a linear combination of a maximum of two of x₁, x₂, ..., and xₜ, where k₁ and k₂ are positive integers.

With reference to any one of the foregoing aspects or the implementations, in some other implementations, shifting values of non-zero elements corresponding to the first sequence or the second sequence are all 0.

With reference to any one of the foregoing aspects or the implementations, in some other implementations, when m is an even number, the non-zero elements in the first square matrix further include a third-type non-zero element, and the third-type non-zero element is located in an $\frac{{m}_{th}}{2}$ row and an $\frac{{m}_{th}}{2}$ column in the first square matrix.

With reference to any one of the foregoing aspects or the implementations, in some other implementations, a shifting value of the third-type non-zero element is not 0; or a shifting value of the third-type non-zero element is determined based on values of xi, x₂, ..., and xₜ, x₁, x₂, ..., and xₜ are all greater than or equal to 0, and t is a positive integer.

With reference to any one of the foregoing aspects or the implementations, in some other implementations, the first square matrix is a 4×4 matrix, and the first square matrix is any one of the following matrices: $\left[\begin{matrix}0 & 0 & 0 & - 1 \\ 0 & x & - 1 & 0 \\ 0 & - 1 & x & - x \\ - 1 & 0 & x & - 3 x\end{matrix}\right] , \left[\begin{matrix}0 & 0 & 0 & - 1 \\ 0 & x & - 1 & 0 \\ 0 & - 1 & x & - 2 x \\ - 1 & 0 & x & - 4 x\end{matrix}\right] , or \left[\begin{matrix}0 & 0 & 0 & - 1 \\ 0 & x & - 1 & 0 \\ 0 & - 1 & x & - 2 x \\ - 1 & 0 & x & - 3 x\end{matrix}\right] ,$ where
"-1" represents a zero element, "0" represents a non-zero element with a shifting value of 0, "x" represents a non-zero element with a shifting value of x, "-x" represents a non-zero element with a shifting value of Z_{c}-x, "-2x" represents a non-zero element with a shifting value of Z_{c}-2x, "-3x" represents a non-zero element with a shifting value of Z_{c}-3x, "-4x" represents a non-zero element with a shifting value of Z_{c}-4x, Z_{c} is a lifting size, and x is a positive integer.

With reference to any one of the foregoing aspects or the implementations, in some other implementations, the first square matrix is a 5×5 matrix, and the first square matrix is any one of the following matrices: $\left[\begin{matrix}0 & 0 & 0 & - 1 & - 1 \\ 0 & - 1 & - 1 & 0 & 0 \\ 0 & - 1 & x & - 2 x & - 1 \\ - 1 & 0 & - 1 & 0 & - x \\ - 1 & 0 & y & - 1 & 0\end{matrix}\right] , \left[\begin{matrix}0 & 0 & 0 & - 1 & - 1 \\ 0 & - 1 & - 1 & 0 & 0 \\ 0 & - 1 & x & - x & - 1 \\ - 1 & 0 & - 1 & 0 & x \\ - 1 & 0 & y & - 1 & 0\end{matrix}\right] , or \left[\begin{matrix}0 & 0 & 0 & - 1 & - 1 \\ 0 & - 1 & - 1 & 0 & 0 \\ 0 & - 1 & x & x & - 1 \\ - 1 & 0 & - 1 & 0 & x \\ - 1 & 0 & y & - 1 & 0\end{matrix}\right] ,$ where
"-1" represents a zero element, "0" represents a non-zero element with a shifting value of 0, "x" represents a non-zero element with a shifting value of x, "-x" represents a non-zero element with a shifting value of Z_{c}-x, "-2x" represents a non-zero element with a shifting value of Z_{c}-2x, "y" represents a non-zero element with a shifting value of y, Z_{c} is a lifting size, and x and y are positive integers.

With reference to any one of the foregoing aspects or the implementations, in some other implementations, the first matrix region further includes at least one second square matrix, the first square matrix do not overlap the at least one second square matrix, and a second sub-region including the first square matrix and the at least one second square matrix includes all diagonal elements in the first matrix region. Elements in the first matrix region that are in an upper right part of the second sub-region are all zero elements, and elements in the first matrix region that are in a lower left part of the second sub-region are all zero elements; or elements in the first matrix region that are in an upper right part of the second sub-region are all zero elements, and a region that is in the first matrix region and that is in a lower left part of the second sub-region includes a non-zero element; or a region that is in the first matrix region and that is in an upper right part of the second sub-region includes a non-zero element, and elements in the first matrix region that are in a lower left part of the second sub-region are all zero elements.

When a scale of the first matrix region is very large, an encoding process of the first matrix region may be complex, and a quantity of cycles may increase. In the foregoing implementation, the first matrix region may include a plurality of square matrices (including the first square matrix and the at least one second square matrix), and may support block-based encoding, thereby simplifying encoding complexity and reducing a quantity of short cycles.

In addition, when the elements in the first matrix region that are in the upper right part of the second sub-region are all the zero elements and the elements in the first matrix region that are in the lower left part of the second sub-region are all the zero elements, the first square matrix and the at least one second square matrix may be completely encoded in parallel, thereby helping increase an encoding rate. When the elements in the first matrix region that are in the upper right part of the second sub-region are all the zero elements, and the region that is in the first matrix region and that is in the lower left part of the second sub-region includes the non-zero element, or when the region that is in the first matrix region and that is in the upper right part of the second sub-region includes the non-zero element, and the elements in the first matrix region that are in the lower left part of the second sub-region are all the zero elements, a more flexible degree distribution can be supported, thereby helping improve a threshold for decoding the LDPC code.

With reference to any one of the foregoing aspects or the implementations, in some other implementations, the at least one second square matrix is of an upper triangular structure, a lower triangular structure, a diagonal structure, or a dual-diagonal structure. The first square matrix is located in an upper left corner of the first matrix region, the region that is in the first matrix region and that is in the upper right part of the second sub-region includes the non-zero element, and the elements in the first matrix region that are in the lower left part of the second sub-region are all zero elements; or the first square matrix is located in a lower right corner of the first matrix region, the elements in the first matrix region that are in the upper right part of the second sub-region are all zero elements, and the region that is in the first matrix region and that is in the lower left part of the second sub-region includes the non-zero element.

This solution in the foregoing embodiments has an advantage of implementing a column degree of an encoding structure of at least 3 while simplifying encoding, thereby helping ensure a property that the code distance of the LDPC code linearly increases with the code length.

According to a third aspect, a communication apparatus is provided. The apparatus is configured to perform the method provided in any one of the foregoing aspects or the implementations of the foregoing aspects. Specifically, the apparatus may include a unit and/or a module configured to perform the method provided in any one of the foregoing aspects or the implementations of the foregoing aspects, for example, a processing unit and/or a transceiver unit.

In an implementation, the apparatus is a transmitter device or a receiver device. When the apparatus is the transmitter device or the receiver device, the transceiver unit may be a transceiver, an input/output interface, or a communication interface; and the processing unit may be at least one processor. Optionally, the transceiver is a transceiver circuit. Optionally, the input/output interface is an input/output circuit.

In another implementation, the apparatus is a chip, a chip system, or a circuit that is used in a transmitter device or a receiver device. When the apparatus is the chip, the chip system, or the circuit that is used in the transmitter device or the receiver device, the transceiver unit may be an input/output interface, an interface circuit, an output circuit, an input circuit, a pin, a related circuit, or the like on the chip, the chip system, or the circuit; and the processing unit may be at least one processor, a processing circuit, a logic circuit, or the like.

According to a fourth aspect, a communication apparatus is provided. The apparatus includes: a memory, configured to store a program; and at least one processor, configured to execute the computer program or instructions stored in the memory, to perform the method provided in any one of the foregoing aspects or the implementations of the foregoing aspects.

In an implementation, the apparatus is a transmitter device or a receiver device.

In another implementation, the apparatus is a chip, a chip system, or a circuit that is used in a transmitter device or a receiver device.

According to a fifth aspect, a communication apparatus is provided. The apparatus includes at least one processor and a communication interface. The at least one processor is configured to obtain, through the communication interface, a computer program or instructions stored in a memory, to perform the method provided in any one of the foregoing aspects or the implementations of the foregoing aspects. The communication interface may be implemented by hardware or software.

In an implementation, the apparatus further includes the memory.

According to a sixth aspect, a processor is provided, and is configured to perform the methods provided in the foregoing aspects.

Unless otherwise specified, or if operations such as sending and obtaining/receiving related to the processor do not conflict with actual functions or internal logic of the operations in related descriptions, the operations may be understood as operations such as an output, receiving, and an input of the processor, or may be understood as sending and receiving operations performed by a radio frequency circuit and an antenna. This is not limited in this application.

According to a seventh aspect, a computer-readable storage medium is provided. The computer-readable medium stores program code to be executed by a device. The program code is used to perform the method provided in any one of the foregoing aspects or the implementations of the foregoing aspects.

According to an eighth aspect, a computer program product including instructions is provided. When the computer program product runs on a computer, the computer is enabled to perform the method provided in any one of the foregoing aspects or the implementations of the foregoing aspects.

According to a ninth aspect, a chip is provided. The chip includes a processor and a communication interface. The processor reads, through the communication interface, instructions stored in a memory, to perform the method provided in any one of the foregoing aspects or the implementations of the foregoing aspects. The communication interface may be implemented by hardware or software.

Optionally, in an implementation, the chip further includes the memory. The memory stores a computer program or the instructions. The processor is configured to execute the computer program or the instructions stored in the memory. When the computer program or the instructions are executed, the processor is configured to perform the method provided in any one of the foregoing aspects or the implementations of the foregoing aspects.

When the methods provided in this application are performed by the chip, a quantity of chips that specifically implement the methods in this application is not limited in this application. For example, the methods may be performed by one chip, or may be performed by two or more chips. In addition, when there are two or more chips that implement the methods in this application, a chip vendor is not limited. The chips may be from a same vendor or from different vendors.

According to a tenth aspect, a communication system is provided, and includes at least one of the transmitter device or the receiver device described above.

According to an eleventh aspect, a computer program is provided. When the computer program is run on a computer, the method provided in any one of the foregoing aspects or the implementations of the foregoing aspects is performed.

### BRIEF DESCRIPTION OF DRAWINGS

FIG. 1 is a diagram of a network architecture to which an embodiment of this application may be applied;
FIG. 2 is a diagram of a parity check matrix H of LDPC;
FIG. 3 shows a Tanner (Tanner) graph of a parity check matrix H of LDPC;
FIG. 4A and FIG. 4B are diagrams of structures of a parity check matrix;
FIG. 5 is a diagram of an information transmission procedure;
FIG. 6 is a diagram of encoding structures of an irregular repeat-accumulate (irregular repeat-accumulate, IRA) code at different code rates;
FIG. 7 is a schematic flowchart of an LDPC code-based communication method 700 according to this application;
FIG. 8A to FIG. 8C each show an example of a first-type edge;
FIG. 9A to FIG. 9C each show an example of a second-type edge;
FIG. 10 shows another example of a second-type edge;
FIG. 11A and FIG. 11B each show another example of a second-type edge;
FIG. 12A to FIG. 12C each show an example of a third-type edge;
FIG. 13 shows an example of a block included in a region B;
FIG. 14A and FIG. 14B each show a specific example of a block included in a region B;
FIG. 15A to FIG. 15C each show another example of a block included in a region B;
FIG. 16A to FIG. 16C each show another example of a block included in a region B;
FIG. 17 is a schematic flowchart of an LDPC code-based communication method 1700 according to this application;
FIG. 18A to FIG. 18D show simulation results of signal-to-noise ratios (signal-to-noise ratios, SNRs) of a base graph (base graph, BG) 2 raptor-like encoding structure and a 3-regular encoding structure of this application at different code lengths and different block error ratios (block error ratios, BLERs);
FIG. 19 shows simulation results of SNRs of a BG 1 dual-diagonal encoding structure and a 3-regular encoding structure of this application at different lifting sizes;
FIG. 20 is a diagram of a structure of an apparatus according to an embodiment of this application;
FIG. 21 is a diagram of another structure of an apparatus according to an embodiment of this application; and
FIG. 22 is a diagram of a chip system according to an embodiment of this application.

### DESCRIPTION OF EMBODIMENTS

For ease of understanding embodiments of this application, before embodiments of this application are described, the following descriptions are first provided.

"Used to indicate" or "indicate" may include a direct indication and an indirect indication, in other words, "used to indicate" or "indicate" may be an explicit indication and/or an implicit indication. Various numbers such as first and second are merely used for differentiation for ease of description, and are not used to limit the scope of embodiments of this application, for example, to distinguish between different messages and different information. "Predefinition" may be implemented by pre-storing corresponding code or a corresponding table in a device, or may be implemented in another manner that may indicate related information. A specific implementation of the predefinition is not limited in this application. A related "protocol" may be a standard protocol in the communication field, for example, may include a long term evolution (long term evolution, LTE) protocol, a new radio (new radio, NR) protocol, and a related protocol applied to a future communication system. This is not limited in this application. Words such as "example", "for example", "example", and "in an (another) example" represent giving an example, an illustration, or a description. Any embodiment or design scheme described as an "example" in this application shall not be construed as being more preferred or more advantageous than another embodiment or design scheme. The terms "include", "contain", "have", and variants thereof all mean "include but are not limited to", unless otherwise specifically emphasized in another manner. "At least one" means one or more, and "a plurality of' means two or more. "At most one" means one or zero. "And/or" describes an association between associated objects, and indicates that three relationships may exist. For example, A and/or B may indicate the following three cases: Only A exists, both A and B exist, and only B exists, where A and B may be singular or plural. The character "/" usually indicates an "or" relationship between the associated objects. At least one of the following items (pieces) or a similar expression thereof indicates any combination of these items, including a single item (piece) or any combination of a plurality of items (pieces). For example, at least one of a, b, and c may indicate a, b, c, a and b, a and c, b and c, or a, b, and c. Each of a, b, and c may be singular or plural. Related descriptions about sending a message, information, or data by a network element A to a network element B, and receiving the message, information, or data by the network element B from the network element A are intended to describe a network element to which the message, information, or data is to be sent. Whether the message, information, or data is directly sent or indirectly sent via another network element is not limited. Descriptions such as "when...", "in a case of...", "in response to", and "if" all mean that a device performs corresponding processing in a specific objective situation, where time is not limited, the device is not necessarily required to perform a determining action during implementation, and there are no other limitations.

In addition, a network architecture and a service scenario described in embodiments of this application are intended to describe the technical solutions in embodiments of this application more clearly, and do not constitute a limitation on the technical solutions provided in embodiments of this application. A person of ordinary skill in the art may know that: With the evolution of the network architecture and the emergence of new service scenarios, the technical solutions provided in embodiments of this application are also applicable to similar technical problems.

The following describes a communication system to which embodiments of this application may be applied.

Embodiments of this application may be applied to various communication systems, including but not limited to a 5th generation (5th generation, 5G) system or an NR system, an LTE system, a long term evolution-advanced (long term evolution-advanced, LTE-A) system, an LTE frequency division duplex (frequency division duplex, FDD) system, an LTE time division duplex (time division duplex, TDD) system, and the like. Embodiments of this application may be further applied to a future communication system, for example, a 6th generation mobile communication system. In addition, embodiments of this application may be further applied to device-to-device (device-to-device, D2D) communication, vehicle-to-everything (vehicle-to-everything, V2X) communication, machine-to-machine (machine-to-machine, M2M) communication, machine type communication (machine type communication, MTC), an internet of things (internet of things, IoT) communication system, a narrow band-internet of things (narrow band-internet of things, NB-IoT) system, or another communication system. In addition, embodiments of this application may be further extended to a similar wireless communication system, for example, a communication system related to wireless fidelity (wireless fidelity, Wi-Fi), worldwide interoperability for microwave access (worldwide interoperability for microwave access, WiMAX), and the 3rd generation partnership project (3rd generation partnership project, 3GPP). This is not limited.

The communication system applicable to embodiments of this application may include one or more transmitter devices and one or more receiver devices. Optionally, one of the transmitter device and the receiver device may be a terminal device, and the other may be a network device. Optionally, both the transmitter device and the receiver device may be terminal devices. Optionally, both the transmitter device and the receiver device may be network devices.

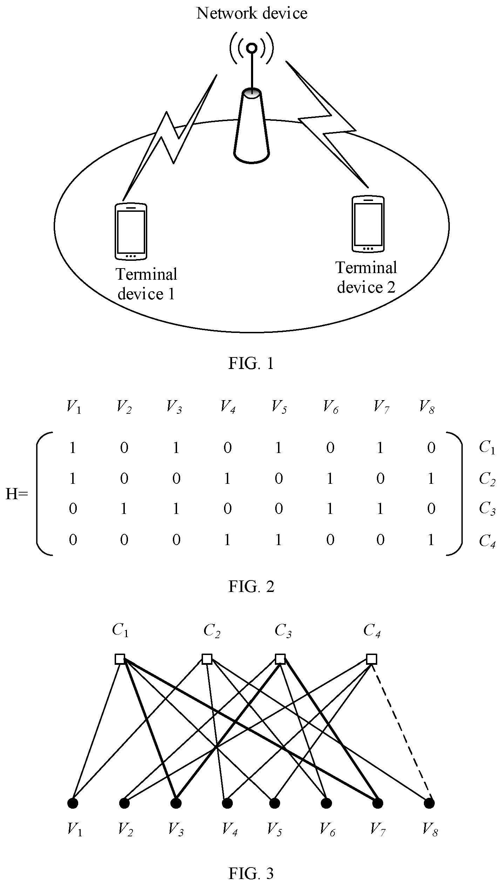

For example, FIG. 1 is a diagram of a network architecture to which an embodiment of this application is applicable.

As shown in FIG. 1, embodiments of this application are applicable to both uplink data transmission and downlink data transmission. In FIG. 1, only uplink data transmission or downlink data transmission between one network device and two terminal devices (for example, a terminal device 1 and a terminal device 2) is used as an example. In the uplink data transmission, in this specification, a transmitter device is the terminal device, and a receiver device is the network device. On the contrary, in the downlink data transmission, a transmitter device is the network device, and a receiver device is the terminal device. In addition, applicability of embodiments of this application in another communication scenario is not limited. For example, embodiments of this application may also be applied to sidelink communication.

The terminal device in this application may also be referred to as user equipment (user equipment, UE), an access terminal, a subscriber unit, a subscriber station, a mobile station, a mobile console, a mobile terminal (mobile terminal, MT), a remote station, a remote terminal, a mobile device, a user terminal, a terminal, an uncrewed aerial vehicle, a wireless communication device, a user agent, or a user apparatus. The terminal device in embodiments of this application may be a device that provides voice and/or data connectivity for a user, and may be configured to connect a person, an object, and a machine, for example, a handheld device or a vehicle-mounted device having a wireless connection function. The terminal device in embodiments of this application may be a mobile phone (mobile phone), a tablet computer (pad), a notebook computer, a palmtop computer, a mobile internet device (mobile internet device, MID), a wearable device, a virtual reality (virtual reality, VR) device, an augmented reality (augmented reality, AR) device, a wireless terminal in industrial control (industrial control), a wireless terminal in self-driving (self-driving), a wireless terminal in remote medical surgery (remote medical surgery), a wireless terminal in a smart grid (smart grid), a wireless terminal in transportation safety (transportation safety), a wireless terminal in a smart city (smart city), a wireless terminal in a smart home (smart home), or the like.

The network device in this application may be a device having a wireless transceiver function. The network device may be a device that provides a wireless communication function service, is usually located on a network side, and includes but is not limited to a next generation base station (gNodeB, gNB) in a 5G system, a base station in a sixth generation mobile communication system, a base station in a future mobile communication system, an access node in a wireless fidelity (wireless fidelity, Wi-Fi) system, an evolved node B (evolved node B, eNB) in a long term evolution (long term evolution, LTE) system, a radio network controller (radio network controller, RNC), a node B (node B, NB), a base station controller (base station controller, BSC), a home base station (for example, a home evolved NodeB or a home NodeB, HNB), a base band unit (base band unit, BBU), a transmission and reception point (transmission and reception point, TRP), a transmitting point (transmitting point, TP), a base transceiver station (base transceiver station, BTS), a satellite, an unmanned aerial vehicle, and the like. In a network structure, the network device may include a central unit (central unit, CU) node, or a distributed unit (distributed unit, DU) node, or a RAN device including a CU node and a DU node, or a RAN device including a CU-control plane node, a CU-user plane node, and a DU node. Alternatively, the network device may be a radio controller, a relay station, a vehicle-mounted device, a wearable device, and the like in a cloud radio access network (cloud radio access network, CRAN) scenario. In addition, the base station may be a macro base station, a micro base station, a relay node, a donor node, or a combination thereof. The base station may alternatively be a communication module, a modem, or a chip that is disposed in the foregoing device or apparatus. The base station may alternatively be a mobile switching center, a device that functions as a base station in D2D, V2X, and M2M communication, a network side device in a 6G network, a device that functions as a base station in a future communication system, or the like. The base station can support networks using a same access technology or different access technologies. This is not limited.

Unless otherwise specified, in this application, an apparatus configured to implement a function of the terminal device or the network device may be the terminal device or the network device, or may be an apparatus that can support the terminal device or the network device in implementing the function, for example, a chip system or a chip. Specifically, the apparatus is a system on a chip (system on a chip, SoC) or a modem (Modem). The apparatus may be mounted in the terminal device or the network device. In embodiments of this application, the chip system may include a chip, or may include a chip and another discrete component.

It should be further noted that in some embodiments of this specification, a 5G system is used as an example to describe details of specific solutions. It may be understood that when the solutions are applied to another communication system, for example, an LTE system or a future communication system, messages, channels, information, or the like in the solutions may be replaced with messages, channels, information, or the like that can be used to implement corresponding functions in the another communication system. This is not limited in this application.

In addition, embodiments of this application may be applied to various application scenarios, for example, a high throughput scenario, a high reliability scenario, a low latency scenario, a high-reliability and low-latency scenario, or a low power consumption scenario. The high-throughput scenario may be, for example, an enhanced mobile broadband (Enhanced Mobile Broadband, eMBB) scenario. The high-reliability and low-latency scenario may be, for example, a URLLC (Ultra Reliable Low Latency Communication) scenario. The low power consumption scenario may be, for example, an M2M scenario, an MTC scenario, or an IoT scenario.

To facilitate understanding of embodiments of this application, several concepts or terms in embodiments of this application are briefly described. The concepts or the terms described below are described based on concepts or terms specified in a protocol. However, this does not mean that embodiments of this application can be applied only to a current existing system, and the concepts or the terms in embodiments of this application can be applied to a future system. In addition, specific names of the concepts or the terms (for example, concepts or terms related to functional descriptions) may be adjusted with development of the future system.

### 1. LDPC code

The LDPC code is a linear block code, and a parity check matrix of the LDPC code is a sparse matrix. In the parity check matrix of LDPC, a quantity of zero elements is far greater than a quantity of non-zero elements. In other words, a row weight and a column weight of the parity check matrix are much less than a code length of the LDPC. An LDPC code whose information bit sequence length is equal to q and whose code length is equal to n may be uniquely determined based on a parity check matrix of the LDPC code.

In 1981, Tanner (Tanner) represented LDPC codewords in a graph. This graph now is referred to as a Tanner graph. The Tanner graph and a parity check matrix are in a one-to-one correspondence. The Tanner graph includes two types of vertices. One type of vertex represents codeword bits and is referred to as a variable node. The other type of vertex is a check node and represents a check constraint relationship. Each check node represents one check constraint relationship. The following provides descriptions with reference to FIG. 2 and FIG. 3.

FIG. 2 is a diagram of a parity check matrix H of LDPC.

In FIG. 2, {Vᵢ} represents a variable node (variable node, VN) set, and {Cᵢ} represents a check node (check node, CN) set. In the parity check matrix H, each row represents one check equation, each check equation corresponds to one check node, each column represents one codeword bit, and each codeword bit corresponds to one variable node. In FIG. 2, there are eight variable nodes and four check nodes. If a codeword bit is included in a corresponding check equation, a related variable node and check node are connected by using a connection line, to obtain a Tanner graph.

FIG. 3 shows a Tanner graph of a parity check matrix H of LDPC.

As shown in FIG. 3, the Tanner graph represents the parity check matrix of LDPC. For example, for the parity check matrix H with a size of m rows and n columns, the Tanner graph includes two types of nodes: n variable nodes and m check nodes. The n variable nodes respectively correspond to the n columns in the parity check matrix H, and the m check nodes respectively correspond to the m rows in the parity check matrix H. A cycle in the Tanner graph consists of connected vertices. The cycle uses one of the vertices as both a start point and an end point, and passes through each node only once. A length of the cycle is defined as a quantity of connection lines included in the cycle. A girth of a graph may also be referred to as a size of the graph, and is defined as a minimum cycle length in the graph. In FIG. 3, a girth is 4, as shown by bold connection lines in FIG. 3. The variable nodes in the Tanner graph each correspond to one column in the parity check matrix H, that is, correspond to each codeword bit of LDPC. The check nodes in the Tanner graph each correspond to one row in the parity check matrix H, that is, correspond to one parity bit of LDPC. A connection between the two types of nodes corresponds to a value of an element in the matrix H. If there is a connection between an i^{th} check node and a j^{th} variable node, it indicates that a value of an element (i, j) in the matrix H is 1. If there is no connection between an i^{th} check node and a j^{th} variable node, it indicates that a value of a corresponding element is 0. A connection line between the variable node and the check node may also be referred to as an edge. That there is the connection between the check node and the variable node may also be described as that there is a connection or an edge between the check node and the variable node. An edge relationship between the check node and the variable node may include two cases: there is an edge or there is no edge.

In addition, in the Tanner graph, the cycle (cycle) is a closed loop formed by a variable node, a check node, and an edge that are connected end to end.

As described above, the LDPC code is the linear block code. In the linear block code, a to-be-encoded information sequence is divided into groups in q bits, and an encoder performs a linear operation on the q information bits to obtain m parity bits. Then, the q information bits are combined with the m parity bits to obtain a codeword whose length is n=q+m. A mapping relationship between the q information bits and the codeword whose length is n bits is usually represented by a corresponding parity check matrix H. A codeword sequence may be correspondingly generated based on the parity check matrix H to complete an encoding process. After the codeword sequence is transmitted through a channel, a receiver device correspondingly decodes a received signal, to determine an original information bit.

### 2. QC-LDPC code

The quasi-cyclic low-density parity check (quasi-cyclic low-density parity check, QC-LDPC) code is a type of structured LDPC code. Due to a unique structure of a parity check matrix of the QC-LDPC code, a simple feedback shift register can be used for encoding, to reduce encoding complexity of the LDPC code. When a code length is long, the parity check matrix H of the LDPC code is very large. Therefore, H is usually represented in blocks. The complete parity check matrix H is considered as being generated by using a plurality of Z_{c}×Z_{c} submatrices. Specifically, the complete parity check matrix H may be represented by a base matrix H_{b}, each element in H_{b} corresponds to one Z_{c}×Z_{c} submatrix, and each submatrix may be represented by a quantity of cyclic shift bits. Therefore, storage space required by the complete parity check matrix H is greatly reduced. The element in the base matrix H_{b} may also be referred to as a quasi-cyclic (quasi-cyclic, QC) block.

Based on the base matrix H_{b} and a lifting size Z_{c} (lifting size), the base matrix H_{b} may be extended to the complete parity check matrix for encoding or decoding. Z_{c} may also be referred to as an extension factor, a lifting factor, an extension value, an extension coefficient, a lifting size, or the like.

For example, the base matrix H_{b} of the QC-LDPC code is as follows: $\left[\begin{matrix}13 & 48 & 80 & 66 & 4 & 74 & 7 & 30 & 76 & 52 & 37 & 60 & - 1 & 49 & - 1 & 73 & 31 & 74 & 73 & 23 & 1 & 0 & - 1 & - 1 \\ 69 & 63 & 74 & 56 & 64 & 77 & 57 & 65 & 6 & 16 & 51 & - 1 & 64 & - 1 & 64 & 68 & 9 & 48 & 62 & 54 & - 1 & 0 & 0 & - 1 \\ 51 & 15 & 0 & 80 & 24 & 25 & 42 & 54 & 44 & 71 & 71 & 9 & 67 & 35 & 67 & - 1 & 58 & - 1 & 29 & - 1 & 0 & - 1 & 0 & 0 \\ 16 & 29 & 36 & 41 & 44 & 56 & 59 & 37 & 50 & 24 & - 1 & 65 & 4 & 65 & 4 & 52 & - 1 & 4 & - 1 & 73 & 1 & - 1 & - 1 & 0\end{matrix}\right]$

It can be learned that a size of the base matrix H_{b} is 4 rows and 24 columns, each element in the base matrix H_{b} represents a Z_{c}-order square matrix, an element ${P}_{{Z}_{c}}^{i}$ represents a cyclic permutation matrix, i represents a cyclic shifting value, and i is an integer. In addition, "-1" in the base matrix H_{b} represents an all-zero matrix, and "0" represents an identity matrix.

For example, ${P}_{{Z}_{c}}^{1}$ is as follows: ${P}_{{Z}_{c}}^{1} = \left[\begin{matrix}0 & 1 & 0 & … & 0 \\ 0 & 0 & 1 & … & 0 \\ ⋮ & ⋮ & ⋮ & ⋱ & ⋮ \\ 0 & 0 & 0 & … & 1 \\ 1 & 0 & 0 & … & 0\end{matrix}\right]$

Optionally, in addition to "-1", a zero element in the base matrix H_{b} may also be expressed in another form. For example, the all-zero matrix is represented by "-" or a null value.

The base matrix may also be referred to as a base graph (BG).

A BG model of the QC-LDPC code is BG = (X, Y, F), where X corresponds to a variable, Y corresponds to a check equation, and F is an edge relationship. A Tanner graph is obtained through QC expansion with a lifting size of Z_{c}, namely, a bipartite graph G = (V, C, E), where V is a variable node, C is a check node, E is an edge relationship between the variable node and the check node, a quantity of corresponding columns in the parity check matrix N = |V| = Z_{c}|X|, a quantity of rows in the parity check matrix M = |C| = Z_{c}|Y|, and a quantity of non-zero elements in the parity check matrix |E| = Z_{c}|F|.

A quantity of information bits supported by a current data channel ranges from 1 to 8448, and there are two check matrices described in the standard: BG₁ and BG₂. For one BG, different Z_{c} values need to be used to adapt to rate matching of different code lengths. Therefore, a Z_{c} list and a shifting value list need to be stored, so that rate matching can be performed based on the Z_{c} list and the shifting value list.

### 3. Non-zero element and zero element

In a parity check matrix, a zero element represents that there is no connection or edge between a variable node and a check node, and a non-zero element represents that there is a connection or an edge between the variable node and the check node.

In an LDPC base matrix, a zero element represents a Z_{c}-order all-zero square matrix, a non-zero element represents a Z_{c}-order identity matrix or a cyclic permutation matrix based on a Z_{c}-order identity matrix, and a value of the non-zero element represents a cyclic shifting value or a shifting value (shifting value, SV) relative to the identity matrix.

Specific representation forms of the zero element and the non-zero element are not limited in this application. For example, in the parity check matrix H shown in FIG. 2, a zero element is represented by "0", and a non-zero element is represented by "1". For another example, in the base matrix H_{b} described above, a zero element is represented by "-1", and a non-zero element is represented by a "non-negative value".

### 4. Column weight and row weight

For a column in a matrix, a column weight may be a quantity of non-zero elements included in the column. The column weight may also be referred to as column degree or degree of column.

For a row in the matrix, a row weight may be a quantity of non-zero elements included in the row. The row weight may also be referred to as a row degree or degree of row.

For example, as shown in FIG. 2, in the parity check matrix H, a column weight of a first column is 2, and a row weight of a first row is 4. For another example, in the base matrix H_{b} described above, a column weight of a first column is 4, and a row weight of a first row is 20.

### 5. Structure of a parity check matrix

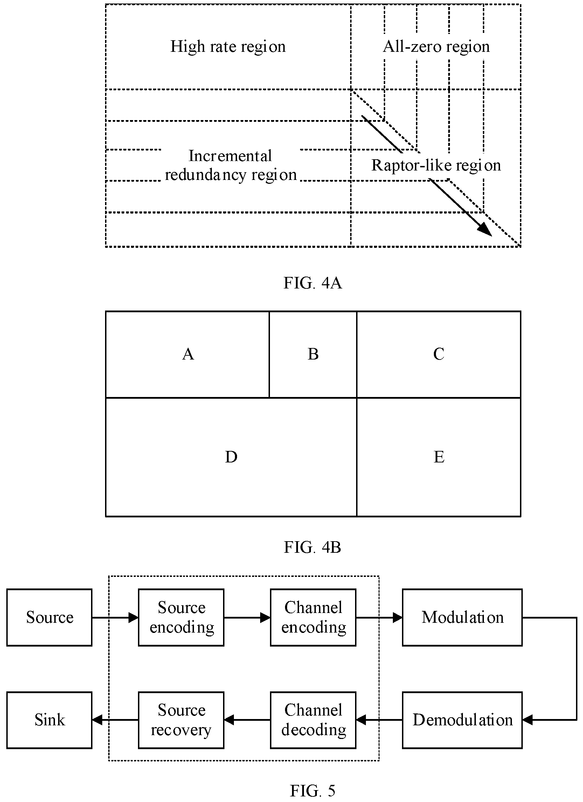

FIG. 4A and FIG. 4B are a diagram of the structure of the parity check matrix.

As shown in FIG. 4A, the parity check matrix may include a high rate region (high rate region), an all-zero region, an incremental redundancy region (incremental redundancy region), and a raptor-like region (raptor-like region). The high rate region may include a part A and a part B shown in FIG. 4B. The part A corresponds to an information bit (or referred to as an information bit, a system bit, or the like), and the part B is a square matrix and corresponds to a kernel parity bit (or referred to as a kernel check bit). The all-zero region may correspond to a part C in FIG. 4B, and is an all-zero matrix. The incremental redundancy region (incremental redundancy region) may correspond to a part D in FIG. 4B. The raptor-like region may correspond to a part E in FIG. 4B, may be an identity matrix, and corresponds to a parity bit extended at a low code rate.

The parity check matrix of the LDPC code shown in FIG. 4A and FIG. 4B uses a "raptor-like" structure, and may be gradually extended to a low code rate through a kernel matrix with a high code rate. During actual use, as shown in FIG. 4A, the first X rows and the first Y columns in the parity check matrix may be intercepted. As code rates are in descending order, X and Y gradually increase, and a region in which the matrix is used also gradually increases.

It should be noted that the parity check matrix may be represented by an LDPC base matrix. Therefore, a structure of the LDPC base matrix is similar to the structure of the parity check matrix, and details are not described herein again.

### 6. Information column and parity column

Columns in an LDPC base matrix include information columns and parity columns.

The information columns correspond to information bits (or referred to as information digits, system bits, or the like), and are columns corresponding to a part A.

The parity columns correspond to parity bits (or check bits), and may include kernel parity columns and extended parity columns, where the kernel parity columns are columns corresponding to a part B, and the extended parity column are columns corresponding to a part C or a part E. The extended parity columns may also be referred to as raptor-like columns. The extended parity columns correspond to extended nodes.

### 7. Kernel row, kernel column, and kernel matrix

Kernel row: Kernel rows in an LDPC base matrix are rows corresponding to kernel parity bits. In other words, the kernel rows are rows corresponding to a high rate region, or rows corresponding to a part A, a part B, or a part C.

Kernel column: Kernel columns may include all information columns and all kernel parity columns. In other words, the kernel columns are columns corresponding to the high rate region, or columns corresponding to the part A and the part B.

Kernel matrix (Kernel Matrix): The kernel matrix is a matrix region including all kernel rows and all kernel columns in the LDPC base matrix. In other words, the kernel matrix is the high rate region of the LDPC base matrix, or a part including the part A and the part B.

### 8. Information transmission procedure

FIG. 5 is a diagram of the information transmission procedure. As shown in FIG. 5, information is sent by a source, and after processing such as source encoding, channel encoding, modulation, air interface transmission, demodulation, channel decoding, and source recovery, the information arrives at a sink, so that transmission of the information from the source to the sink is completed. In FIG. 5, processing (including source encoding, channel encoding, modulation, and the like) shown at an upper layer is performed at a transmitter device, and processing (including demodulation, channel decoding, source recovery, and the like) shown at a lower layer is performed at a receiver device. Embodiments of this application mainly relate to source encoding, channel encoding, channel decoding, and source recovery shown in FIG. 5.

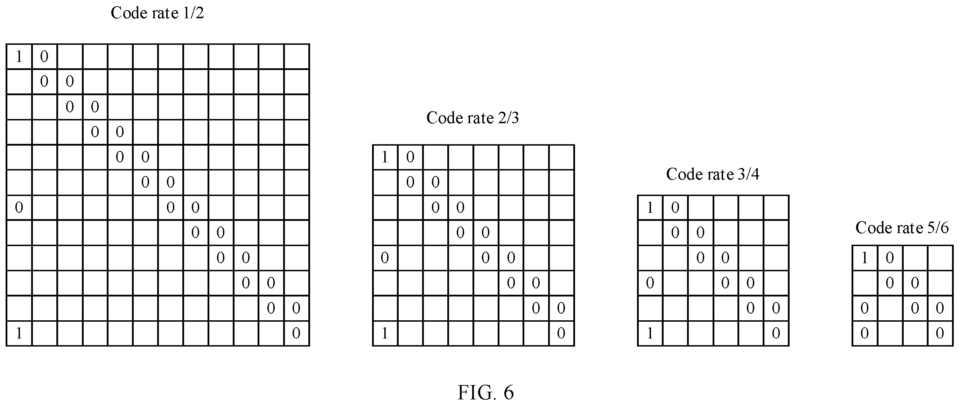

In a current LDPC code, an encoding structure of an LDPC base matrix imposes a large limitation on a degree distribution, and the encoding structure has a small weight. This is not conducive to fast convergence, affecting encoding or decoding performance. For example, an encoding structure of an IRA code is a dual-diagonal structure. Main features of the encoding structure are as follows: A dual-diagonal structure and one column having a column weight being 3 is included, a degree distribution is one column having a column weight being 3 and several columns having column weights being 2, and a coupling structure is provided. FIG. 6 is a diagram of encoding structures of an IRA code at different code rates. A blank block represents a zero element, "0" represents a non-zero element with a shifting value of 0 (namely, an identity matrix), and "1" represents a non-zero element with a shifting value of 1. The encoding structure of the IRA code imposes a large limitation on a degree distribution. The dual-diagonal structure has a small column weight, and nodes whose column weights are 2 are coupled to each other. Consequently, it is difficult to ensure a code distance, and the dual-diagonal structure is not applicable to a high-reliability and low-latency scenario. The encoding structure of the IRA code has a small weight (or a low edge density), which is not conducive to fast convergence and is not applicable to a high-throughput scenario. For another example, a raptor-like encoding structure is an identity matrix, column degrees of the encoding structure are all 1, and the encoding structure imposes a larger limitation on a degree distribution and has low flexibility, which is not conducive to an error floor required in a high-reliability and low-latency scenario and fast convergence required in a high-throughput scenario. For another example, in a lower triangular encoding structure or an upper triangular encoding structure, there is a non-zero element only on a diagonal and below (or above) the diagonal, and there are also a specific quantity of columns whose column degrees are 1, which is also not conducive to an error floor required in a high-reliability and low-latency scenario and fast convergence required in a high-throughput scenario.

To resolve the foregoing problems, this application provides an LDPC code-based communication method and a communication apparatus, to improve flexibility of a degree distribution and an edge density of an encoding structure of an LDPC base matrix, thereby implementing fast convergence and improving encoding or decoding performance.

The following describes method embodiments of this application with reference to the accompanying drawings.

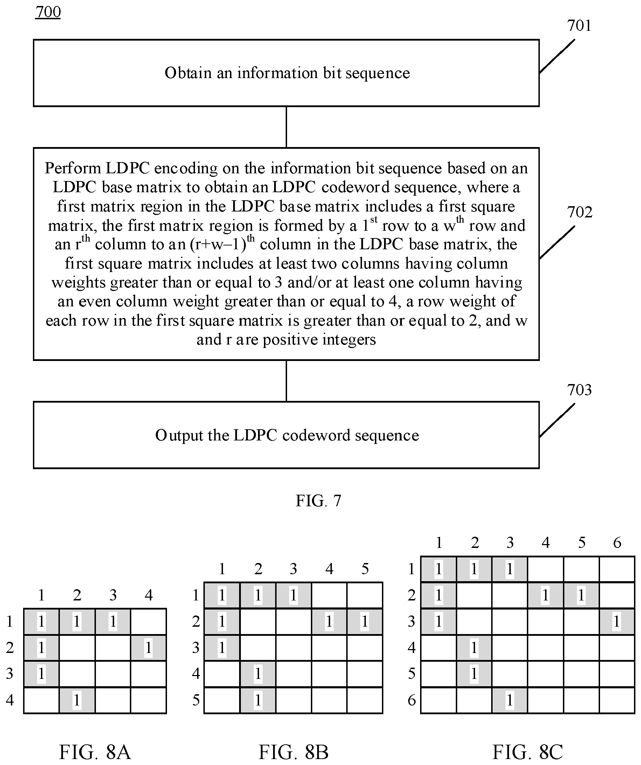

FIG. 7 is a schematic flowchart of an LDPC code-based communication method 700 according to this application.

The method 700 may be performed by a transmitter device. Unless otherwise specified, the "transmitter device" may be a transmitter device, or may be an apparatus that can support a transmitter device in implementing a function of the transmitter device. For ease of description, the transmitter device is uniformly used below for description. The transmitter device may be a terminal device or a network device.

The method 700 may include at least a part of the following content.

Step 701: The transmitter device obtains an information bit sequence.

To be specific, if the transmitter device needs to communicate with a receiver device, in other words, the transmitter device needs to send a signal to the receiver device, the transmitter device needs to first obtain the information bit sequence corresponding to the signal that needs to be sent to the receiver device.

That the transmitter device obtains the information bit sequence may mean that the transmitter device performs source encoding on a source symbol to generate the information bit sequence. That the transmitter device obtains the information bit sequence may alternatively mean that the transmitter device receives the information bit sequence from another communication apparatus.

Step 702: The transmitter device performs LDPC encoding on the information bit sequence based on an LDPC base matrix, to obtain an LDPC codeword sequence.

The LDPC base matrix may be a base matrix stored in the device or a base matrix predefined in a protocol, or may be a base matrix further obtained based on a stored base matrix or a base matrix predefined in a protocol. This is not limited.

In embodiments of this application, the LDPC base matrix includes a first matrix region, the first matrix region includes a 1^{st} row to a w^{th} row and an r^{th} column to an (r+w-1)^{th} column in the LDPC base matrix, and w and r are positive integers. For example, when the LDPC base matrix may be divided into five regions: A, B, C, D, and E shown in FIG. 4B, the first matrix region may be the region B. The following describes embodiments of this application by using an example in which the first matrix region is the region B.

The first matrix region may include a first square matrix. The first square matrix includes at least two columns having column weights greater than or equal to 3 and/or at least one column having an even column weight greater than or equal to 4, and a row weight of each row in the first square matrix is greater than or equal to 2. An encoding structure of the first square matrix is described in detail below with reference to FIG. 8A to FIG. 8C to FIG. 12A to FIG. 12C.

Step 703: The transmitter device outputs the LDPC codeword sequence.

Subsequently, the transmitter device may map the LDPC codeword sequence to an air interface signal, and send the air interface signal to the receiver device.

In embodiments of this application, a column weight of a column included in the first square matrix of the LDPC base matrix is not limited to 2 or 3, and may be a value other than 2 and 3. For example, the column weight may be greater than 2; or the column weight may be greater than 3; or the column weight may be an even number greater than or equal to 4. In this way, the encoding structure of the first square matrix has a more flexible degree distribution. In addition, the first square matrix includes the at least two columns having column weights greater than or equal to 3 and/or the at least one column having an even column weight greater than or equal to 4, so that the first square matrix has a larger weight or a higher edge density. Therefore, in embodiments of this application, the encoding structure of the LDPC base matrix has a more flexible degree distribution, and the encoding structure has the larger weight or the higher edge density. This helps implement fast convergence and improve encoding or decoding performance.

Embodiments of this application focus on improving the region B in the LDPC base matrix, that is, improving the encoding structure of the LDPC base matrix.

The following describes the encoding structure of the first square matrix in detail.

This embodiment of this application provides three possible degree distributions of the first square matrix. The following separately describes the three possible degree distributions.

### 1. Degree distribution 1

When the first square matrix uses the degree distribution 1, a column weight of each column and a row weight of each row in the first square matrix are both G, and G is greater than or equal to 3. In addition, the first square matrix includes a first row and a second row, a quantity of elements in an intersection between a set of column numbers of columns in which non-zero elements in the first row are located and a set of column numbers of columns in which non-zero elements in the second row are located is 2, the first row and the second row are any two rows in the first square matrix. For example, the set including the column numbers of the columns in which the non-zero elements in the first row are located is {1, 2, 3}, the set including the column numbers of the columns in which the non-zero elements in the second row are located is {2, 3, 4}, and the intersection set of the two sets is {2, 3}.

In other words, a column degree distribution of the first square matrix is G-regular, and a row degree distribution of the first square matrix is G-regular, where G is greater than or equal to 3. The degree distribution 1 may also be referred to as a G-regular degree distribution. For example, when G=3, the degree distribution 1 is a 3-regular degree distribution.

The degree distribution 1 helps a code distance of an LDPC code linearly increase with a code length, and helps construct an encoding structure that is easy to implement coding.

In a possible implementation, the first square matrix includes a first column and a second column, an intersection between a set of row numbers of rows in which non-zero elements in the first column are located and a set of row numbers of rows in which non-zero elements in the first column are located includes a maximum of one row number, and the first column and the second column are any two columns in the first square matrix. Row numbers of any two rows in the first square matrix belong to a set including row numbers of rows in which non-zero elements in a column in the first square matrix are located. In this implementation, the encoding structure of the first square matrix may correspond to a Steiner (Steiner) system.

The following provides some examples of the first square matrix by using G=3 as an example.

### Example 1

The first square matrix is a 4×4 matrix, and zero elements and non-zero elements in the first square matrix may be distributed as follows: $\left[\begin{matrix}1 & 1 & 1 & 0 \\ 1 & 1 & 0 & 1 \\ 1 & 0 & 1 & 1 \\ 0 & 1 & 1 & 1\end{matrix}\right] ,$ where
"0" represents a zero element, and "1" represents a non-zero element.

A specific value (namely, a shifting value) of the non-zero element in the first square matrix is not limited in embodiments of this application.

For example, the first square matrix is the 4×4 matrix, and values of the non-zero elements in the first square matrix may be shown in any one of the following matrices: $\left[\begin{matrix}0 & 0 & 0 & - 1 \\ 0 & x & - 1 & 0 \\ 0 & - 1 & x & - x \\ - 1 & 0 & x & - 3 x\end{matrix}\right] , \left[\begin{matrix}0 & 0 & 0 & - 1 \\ 0 & x & - 1 & 0 \\ 0 & - 1 & x & - 2 x \\ - 1 & 0 & x & - 4 x\end{matrix}\right] , or \left[\begin{matrix}0 & 0 & 0 & - 1 \\ 0 & x & - 1 & 0 \\ 0 & - 1 & x & - 2 x \\ - 1 & 0 & x & - 3 x\end{matrix}\right] ,$ where
"-1" represents a zero element, "0" represents a non-zero element with a shifting value of 0, "x" represents a non-zero element with a shifting value of x, "-x" represents a non-zero element with a shifting value of Z_{c}-x, "-2x" represents a non-zero element with a shifting value of Z_{c}-2x, "-3x" represents a non-zero element with a shifting value of Z_{c}-3x, "-4x" represents a non-zero element with a shifting value of Z_{c}-4x, Z_{c} is a lifting size, and x is a positive integer. It can be learned from the foregoing matrices that shifting values of non-zero elements in the first row and the first column are all 0, each matrix has only one unknown number x with a variable value, and values of all other positions are determined based on the unknown number. The value of x may be any positive integer, and usually ranges from 1 to Z_{c}-1.

### Example 2

The first square matrix is a 5×5 matrix, and zero elements and non-zero elements in the first square matrix may be distributed as follows: $\left[\begin{matrix}1 & 1 & 1 & 0 & 0 \\ 1 & 0 & 0 & 1 & 1 \\ 1 & 0 & 1 & 1 & 0 \\ 0 & 1 & 0 & 1 & 1 \\ 0 & 1 & 1 & 0 & 1\end{matrix}\right] ,$ where
"0" represents a zero element, and "1" represents a non-zero element.

A specific value (namely, a shifting value) of the non-zero element in the first square matrix is not limited in embodiments of this application.

For example, the first square matrix is the 5×5 matrix, and values of the non-zero elements in the first square matrix may be shown in any one of the following matrices: $\left[\begin{matrix}0 & 0 & 0 & - 1 & - 1 \\ 0 & - 1 & - 1 & 0 & 0 \\ 0 & - 1 & x & - 2 x & - 1 \\ - 1 & 0 & - 1 & 0 & - x \\ - 1 & 0 & y & - 1 & 0\end{matrix}\right] , \left[\begin{matrix}0 & 0 & 0 & - 1 & - 1 \\ 0 & - 1 & - 1 & 0 & 0 \\ 0 & - 1 & x & - x & - 1 \\ - 1 & 0 & - 1 & 0 & x \\ - 1 & 0 & y & - 1 & 0\end{matrix}\right] , or \left[\begin{matrix}0 & 0 & 0 & - 1 & - 1 \\ 0 & - 1 & - 1 & 0 & 0 \\ 0 & - 1 & x & x & - 1 \\ - 1 & 0 & - 1 & 0 & x \\ - 1 & 0 & y & - 1 & 0\end{matrix}\right] ,$ where
"-1" represents a zero element, "0" represents a non-zero element with a shifting value of 0, "x" represents a non-zero element with a shifting value of x, "-x" represents a non-zero element with a shifting value of Z_{c}-x, "-2x" represents a non-zero element with a shifting value of Z_{c}-2x, "y" represents a non-zero element with a shifting value of y, Z_{c} is a lifting size, and x and y are positive integers. x and y may be the same or different. It can be learned from the foregoing matrices that shifting values of non-zero elements in the first row and the first column are all 0, each matrix has two unknown numbers x and y with variable values, and values of all other positions are determined based on the unknown numbers. The values of x and y may be any positive integers, and usually range from 1 to Z_{c}-1.

The following provides distribution features of edges in the first square matrix by using an example in which G=3 and the first square matrix is an m×m matrix, where m is a positive integer.

The "edge" may also be referred to as a "non-zero element". The "edge" is uniformly used for description below.

Edges of the first square matrix include a first-type edge, a second-type edge, and an optional third-type edge.

### (1) First-type edge

Positions of first-type edges include: a 1^{st} column to a 3^{rd} column in a 1^{st} row, a 4^{th} column and a 5^{th} column in a 2^{nd} row, ..., and a 2t^{th} column and a (2t+1)^{th} column in a t^{th} row in the first square matrix, and a 1^{st} row to a 3^{rd} row in a 1^{st} column, a 4^{th} row and a 5^{th} row in a 2^{nd} column, ..., and a 2t^{th} row and a (2t+1)^{th} row in a t^{th} column in the first square matrix, where the 2t^{th} column and the (2t+1)^{th} column in the t^{th} row and the 2t^{th} row and the (2t+1)^{th} row in the t^{th} column are applicable when t is greater than or equal to 2.

In other words, the first-type edge is the first edge in each row in the first square matrix or the first edge in each column in the first square matrix.

FIG. 8A to FIG. 8C each show an example of a first-type edge. A light gray block is a position of the first-type edge.

As shown in FIG. 8A, for a 4×4 first square matrix, positions of first-type edges include: a 1^{st} column to a 3^{rd} column in a 1^{st} row and a 4^{th} column in a 2^{nd} row; and a 1^{st} row to a 3^{rd} row in a 1^{st} column and a 4^{th} row in a 2^{nd} column in the first square matrix.

As shown in FIG. 8B, for a 5×5 first square matrix, positions of first-type edges include: a 1^{st} column to a 3^{rd} column in a 1^{st} row and a 4^{th} column and a 5^{th} column in a 2^{nd} row; and a 1^{st} row to a 3^{rd} row in a 1^{st} column and a 4^{th} row and a 5^{th} row in a 2^{nd} column in the first square matrix.

As shown in FIG. 8C, for a 6×6 first square matrix, positions of first-type edges include: a 1^{st} column to a 3^{rd} column in a 1^{st} row, a 4^{th} column and a 5^{th} column in a 2^{nd} row, and a 6^{th} column in a 3^{rd} row, and a 1^{st} row to a 3^{rd} row in a 1^{st} column, a 4^{th} row and a 5^{th} row in a 2^{nd} column, and a 6^{th} row in a 3^{rd} column in the first square matrix.

### (2) Second-type edge

Second-type edges are located in a first sub-region in the first square matrix. The first sub-region is defined by an ${\left(m-\left⌈\frac{m}{2}\right⌉+1\right)}^{th}$ row to an m^{th} row and an ${\left(m-\left⌈\frac{m}{2}\right⌉+1\right)}^{th}$ column to an m^{th} column in the first matrix region.

Positions of the second-type edges may be represented by Q permutations $\left({p}_{1}{p}_{2},…,{p}_{\left⌈\frac{m}{2}\right⌉}\right)$, the Q permutations are pairwise distinct, and Q is a positive integer. The permutation may indicate ${p}_{i} ∈ \left\{1,2,…,\left⌈\frac{m}{2}\right⌉-1,\left⌈\frac{m}{2}\right⌉\right\}$, and pᵢ ≠ pⱼ is applicable to any i≠j, where i and j are positive integers less than or equal to $\left⌈\frac{m}{2}\right⌉$. An i^{th} row in the first sub-region is related to a pᵢ^{th} column, in other words, an element in an i^{th} row and a pᵢ^{th} column in the first sub-region is a non-zero element. A complete permutation indicates that a quantity of edges corresponding to the permutation is a length $\left⌈\frac{m}{2}\right⌉$ of the permutations $\left({p}_{1}{p}_{2},…,{p}_{\left⌈\frac{m}{2}\right⌉}\right)$.

If the positions of the second-type edges are represented by the Q permutations, and the positions of the second-type edges are represented by Q complete permutations, it indicates that a total quantity of edges included in the first sub-region is Q times the length $\left⌈\frac{m}{2}\right⌉$ of the permutations $\left({p}_{1}{p}_{2},…,{p}_{\left⌈\frac{m}{2}\right⌉}\right)$, in other words, $Q \times \left⌈\frac{m}{2}\right⌉$.

For example, when the first square matrix uses the 3-regular degree distribution, the second-type edges may be represented by two permutations whose lengths are $\left⌈\frac{m}{2}\right⌉$. Specifically, the positions of the second-type edges may correspond to two sequences: a first sequence and a second sequence. The first sequence and the second sequence are two permutation forms of $\left\{1,2,…,\left⌈\frac{m}{2}\right⌉-1,\left⌈\frac{m}{2}\right⌉\right\}$. Elements in the first sequence are the same as elements in $\left\{1,2,…,\left⌈\frac{m}{2}\right⌉-1,\left⌈\frac{m}{2}\right⌉\right\}$ , elements in the second sequence are the same as the elements in $\left\{1,2,…,\left⌈\frac{m}{2}\right⌉-1,\left⌈\frac{m}{2}\right⌉\right\}$, and an arrangement order of the elements in the first sequence is different from an arrangement order of the elements in the second sequence. An i^{th} element pᵢ in the first sequence or the second sequence indicates that an element in an i^{th} row and a pᵢ^{th} column in the first sub-region is a non-zero element, where i is a positive integer less than or equal to $\left⌈\frac{m}{2}\right⌉$.

For example, m=5, and $\left\{1,2,…,\left⌈\frac{m}{2}\right⌉-1,\left⌈\frac{m}{2}\right⌉\right\} = \left\{1, 2, 3\right\}$. Permutation forms of {1, 2, 3} include {1, 2, 3}, {1, 3, 2}, {2, 1, 3}, {2, 3, 1}, {3, 1, 2}, and {3, 2, 1}. The first sequence and the second sequence may be any two of the permutation forms of {1, 2, 3}. For example, the first sequence is {1, 2, 3}, and the second sequence is {2, 3, 1}.

A specific permutation manner is not limited in embodiments of this application.

In a possible implementation, at least one of the Q permutations is a cycle. A sequence {1, 2, 3, 4, 5, 6, 7, 8, 9, 10} is used as an example. A sequence obtained through a cycle may be, for example, {1, 2, 3, 4, 5, 6, 7, 8, 9, 10}, {2, 3, 4, 5, 6, 7, 8, 9, 10, 1}, or {3, 4, 5, 6, 7, 8, 9, 10, 1, 2}.

In an example, the permutation $p = \left({p}_{1}{p}_{2},…,{p}_{\left⌈\frac{m}{2}\right⌉}\right)$ meets a condition ${p}_{i} = \left(i+s\right) mod \left(\left⌈\frac{m}{2}\right⌉\right) + 1$ , where s is a constant, and mod represents a remainder operation. Optionally, s is greater than or equal to 0 and less than or equal to $\left⌈\frac{m}{2}\right⌉ - 1$.

In another example, the cycle is a segmental cycle. A sequence {1, 2, 3, 4, 5, 6, 7, 8, 9, 10} is used as an example. It is assumed that the sequence is divided into two segments: {1, 2, 3, 4, 5} and {6, 7, 8, 9, 10}, and each segment is a cycle. A sequence obtained through the cycle may be, for example, {2, 3, 4, 5, 1, 6, 7, 8, 9, 10}, {3, 4, 5, 1, 2, 7, 8, 9, 10, 6}, or {3, 4, 5, 1, 2, 8, 9, 10, 6, 7}.

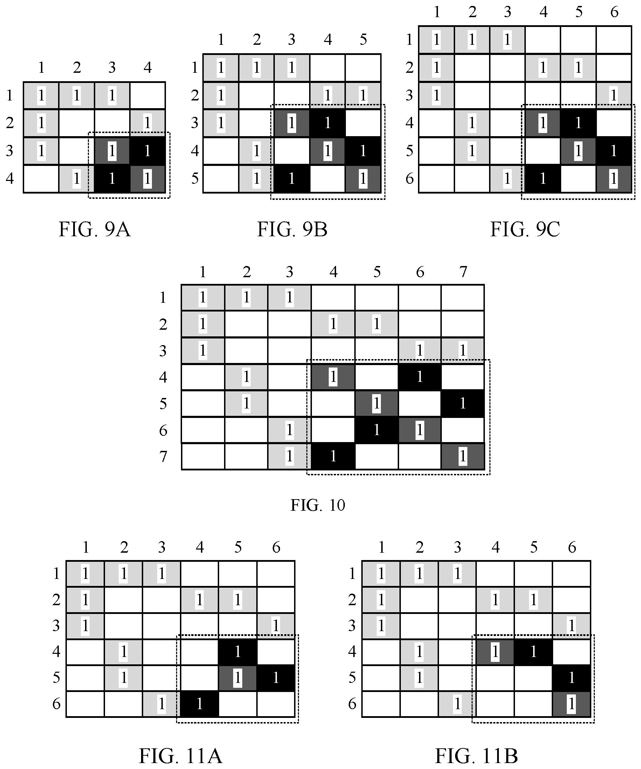

FIG. 9A to FIG. 9C each show an example of a second-type edge.

A dashed-line box is the first sub-region, and a dark gray block and a black block are positions of second-type edges.

As shown in FIG. 9A, for a 4×4 first square matrix, the first sub-region is a region in a 3^{rd} row and a 4^{th} row and a 3^{rd} column and a 4^{th} column in the first square matrix. Positions of dark gray blocks correspond to a permutation 1, and the permutation 1 is a sequence {1, 2}. Positions of black blocks correspond to a permutation 2, and the permutation 2 is a sequence {2, 1}. The permutation 1 and the permutation 2 are two permutation forms of the sequence {1, 2}. {1, 2} indicates that there is an edge in a 1^{st} row and a 1^{st} column in the first sub-region and there is an edge in a 2^{nd} row and a 2^{nd} column in the first sub-region. {2, 1} indicates that there is an edge in a 1^{st} row and a 2^{nd} column in the first sub-region and there is an edge in a 2^{nd} row and a 1^{st} column in the first sub-region. In this case, the positions of the second-type edges include: the 1^{st} row and the 1^{st} column in the first sub-region, the 2^{nd} row and the 2^{nd} column in the first sub-region, the 2^{nd} row and the 1^{st} column in the first sub-region, and the 1^{st} row and the 2^{nd} column in the first sub-region.

As shown in FIG. 9B, for a 5×5 first square matrix, the first sub-region is a region in a 3^{rd} row to a 5^{th} row and a 3^{rd} column to a 5^{th} column in the first square matrix. Positions of dark gray blocks correspond to a permutation 1, and the permutation 1 is a sequence {1, 2, 3}. Positions of black blocks correspond to a permutation 2, and the permutation 2 is a sequence {2, 3, 1}. The permutation 1 and the permutation 2 are two permutation forms of the sequence {1, 2, 3}. {1, 2, 3} indicates that there is an edge in a 1^{st} row and a 1^{st} column in the first sub-region, there is an edge in a 2^{nd} row and a 2^{nd} column in the first sub-region, and there is an edge in a 3^{rd} row and a 3^{rd} column in the first sub-region. {2, 3, 1} indicates that there is an edge in a 1^{st} row and a 2^{nd} column in the first sub-region, there is an edge in a 2^{nd} row and a 3^{rd} column in the first sub-region, and there is an edge in a 3^{rd} row and a 1^{st} column in the first sub-region. In this case, the positions of the second-type edges include: the 1^{st} row and the 1^{st} column in the first sub-region, the 2^{nd} row and the 2^{nd} column in the first sub-region, the 3^{rd} row and the 3^{rd} column in the first sub-region, the 1^{st} row and the 2^{nd} column in the first sub-region, the 2^{nd} row and the 3^{rd} column in the first sub-region, and the 3^{rd} row and the 1^{st} column in the first sub-region.

As shown in FIG. 9C, for a 6×6 first square matrix, the first sub-region is a region in a 4^{th} row to a 6^{th} row and a 4^{th} column to a 6^{th} column in the first square matrix. Positions of dark gray blocks correspond to a permutation 1, and the permutation 1 is a sequence {1, 2, 3}. Positions of black blocks correspond to a permutation 2, and the permutation 2 is a sequence {2, 3, 1}. The permutation 1 and the permutation 2 are two permutation forms of the sequence {1, 2, 3}. {1, 2, 3} indicates that there is an edge in a 1^{st} row and a 1^{st} column in the first sub-region, there is an edge in a 2^{nd} row and a 2^{nd} column in the first sub-region, and there is an edge in a 3^{rd} row and a 3^{rd} column in the first sub-region. {2, 3, 1} indicates that there is an edge in a 1^{st} row and a 2^{nd} column in the first sub-region, there is an edge in a 2^{nd} row and a 3^{rd} column in the first sub-region, and there is an edge in a 3^{rd} row and a 1^{st} column in the first sub-region. In this case, the positions of the second-type edges include: the 1^{st} row and the 1^{st} column in the first sub-region, the 2^{nd} row and the 2^{nd} column in the first sub-region, the 3^{rd} row and the 3^{rd} column in the first sub-region, the 1^{st} row and the 2^{nd} column in the first sub-region, the 2^{nd} row and the 3^{rd} column in the first sub-region, and the 3^{rd} row and the 1^{st} column in the first sub-region.

Both the permutation 1 and the permutation 2 corresponding to the first sub-regions in the three first square matrices shown in FIG. 9A to FIG. 9C are cycles.

FIG. 10 shows another example of a second-type edge.

A dashed-line box is the first sub-region, and a dark gray block and a black block are positions of second-type edges. As shown in FIG. 10, for a 7×7 first square matrix, the first sub-region is a region in a 4^{th} row to a 7^{th} row and a 4^{th} column to a 7^{th} column in the first square matrix. Positions of dark gray blocks correspond to a permutation 1, and the permutation 1 is a sequence {1, 2, 3, 4}. Positions of black blocks correspond to a permutation 2, and the permutation 2 is a sequence {3, 4, 2, 1}. The permutation 1 and the permutation 2 are two permutation forms of the sequence {1, 2, 3, 4}. {1, 2, 3, 4} indicates that there is an edge in a 1^{st} row and a 1^{st} column in the first sub-region, there is an edge in a 2^{nd} row and a 2^{nd} column in the first sub-region, there is an edge in a 3^{rd} row and a 3^{rd} column in the first sub-region, and there is an edge in a 4^{th} row and a 4^{th} column in the first sub-region. {3, 4, 2, 1} indicates that there is an edge in a 1^{st} row and a 3rd column in the first sub-region, there is an edge in a 2^{nd} row and a 4^{th} column in the first sub-region, there is an edge in a 3^{rd} row and a 2^{nd} column in the first sub-region, and there is an edge in a 4^{th} row and a 1^{st} column in the first sub-region. In this case, the positions of the second-type edges include: the 1^{st} row and the 1^{st} column in the first sub-region, the 2^{nd} row and the 2^{nd} column in the first sub-region, the 3^{rd} row and the 3^{rd} column in the first sub-region, the 4^{th} row and the 4^{th} column in the first sub-region, the 1^{st} row and the 3^{rd} column in the first sub-region, the 2^{nd} row and the 4^{th} column in the first sub-region, the 3^{rd} row and the 2^{nd} column in the first sub-region, and the 4^{th} row and the 1^{st} column in the first sub-region.

The permutation 2 corresponding to the first sub-region in the first square matrix shown in FIG. 10 is a segmental cycle. The first square matrix shown in FIG. 10 may correspond to a Steiner system. For descriptions of the Steiner system, refer to the foregoing descriptions.

If there are some columns having column weights being 2 in the first square matrix, the columns are formed by a subset of edges corresponding to two permutations. For example, in the two permutations corresponding to the first sub-region, one permutation may be a complete permutation, and the other permutation may be an incomplete permutation. For another example, the two permutations corresponding to the first sub-region are both incomplete permutations. In this case, the first square matrix actually does not use the 3-regular degree distribution, but uses a degree distribution 3. The degree distribution 3 is described below.

FIG. 11A and FIG. 11B each show another example of a second-type edge.

A dashed-line box is the first sub-region, and a dark gray block and a black block are positions of second-type edges.

As shown in FIG. 11A, for a 6×6 first square matrix, the first sub-region is a region in a 4^{th} row to a 6^{th} row and a 4^{th} column to a 6^{th} column in the first square matrix. Positions of dark gray blocks correspond to a permutation 1, and positions of black blocks correspond to a permutation 2. The permutation 1 is an incomplete permutation of a sequence {1, 2, 3}, and the permutation 2 is a complete permutation of the sequence {1, 2, 3}.

As shown in FIG. 11B, for a 6×6 first square matrix, the first sub-region is a region in a 4^{th} row to a 6^{th} row and a 4^{th} column to a 6^{th} column in the first square matrix. Positions of dark gray blocks correspond to a permutation 1, and positions of black blocks correspond to a permutation 2. Both the permutation 1 and the permutation 2 are incomplete permutations of a sequence {1, 2, 3}.

### (3) Third-type edge

If m is an even number, the first square matrix further includes a third-type edge, and the third-type edge is located in an $\frac{{m}_{th}}{2}$ row and an $\frac{{m}_{th}}{2}$ column in the first square matrix. If m is an odd number, the first square matrix does not include a third-type edge.

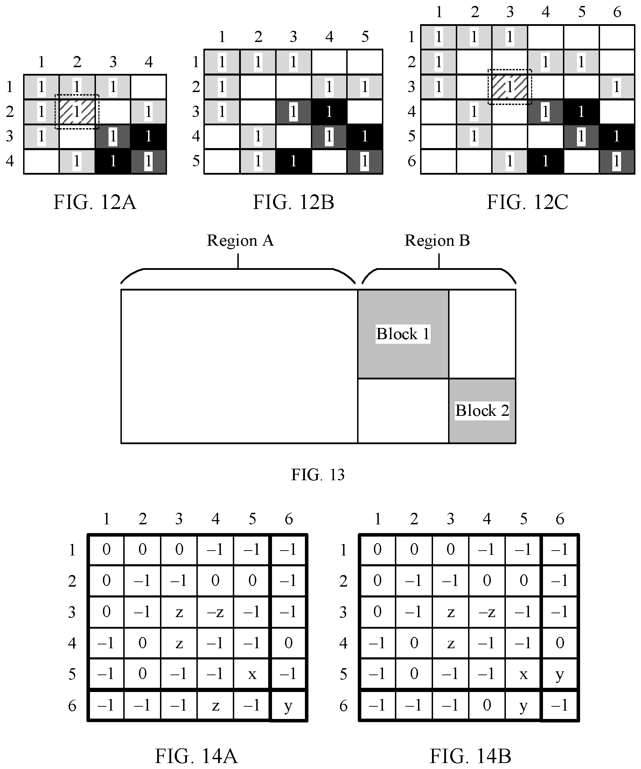

FIG. 12A to FIG. 12C each show an example of a third-type edge.

In FIG. 12A to FIG. 12C, a diagonal-line block is a position of the third-type edge.

As shown in FIG. 12A, for a 4×4 first square matrix, m=4, in other words, m is an even number. In this case, there is a third-type edge in the first square matrix, and a position of the third-type edge is a 2^{nd} row and a 2^{nd} column in the first square matrix.

As shown in FIG. 12B, for a 5×5 first square matrix, m=5, in other words, m is an odd number. In this case, the first square matrix does not include a third-type edge.

As shown in FIG. 12C, for a 6×6 first square matrix, m=6, in other words, m is an even number. In this case, there is a third-type edge in the first square matrix, and a position of the third-type edge is a 3^{rd} row and a 3^{rd} column in the first square matrix.

The foregoing describes the distribution features of the edges in the first square matrix with the 3-regular degree distribution. The following describes features of shifting values of positions (namely, non-zero elements in the first square matrix) of the edges in the first square matrix.

### (1) Shifting value of a position of a first-type edge

In a possible implementation, shifting values of positions of first-type edges may be all 0. If the shifting values are 0, it indicates that a matrix obtained after the positions are increased based on the lifting size is an identity matrix.

### (2) Shifting value of a position of a second-type edge

In a possible implementation, shifting values of positions of second-type edges may be determined based on t values, where the t values are all greater than or equal to 0, and t is a positive integer. It is assumed that the t values are x₁, x₂, ..., and xt, and a shifting value of a position at which there is a second-type edge may be kᵢxᵢ + kⱼxⱼ +. .., where *kᵢ* is an integer. It should be noted that shifting values corresponding to second-type edges at different positions may be the same or different.

For example, t=1.

For example, shifting values at all positions at which there are second-type edges are all x₁.

For another example, shifting values of positions at which there are second-type edges belongs to {xi, -x₁}.

For another example, shifting values of positions at which there are second-type edges may be k₁x₁, where k₁ is a non-negative integer. Shifting values corresponding to second-type edges at different positions may be the same or different. That is, k₁ corresponding to the second-type edges at the different positions may be the same or different. For example, k₁=1, -1, or -3. Shifting values of positions at which there are second-type edges belongs to {x₁, -x₁, -3x₁}, as shown in the first matrix in the values of the non-zero elements in the first square matrix in Example 1.

In the foregoing several examples, elimination methods are changed from simple to complex, with cycle properties gradually improving. During actual implementation, complexity and the cycle properties may be balanced, and an appropriate solution is selected.

For example, t=2.

For example, shifting values of position at which there are second-type edges belongs to {x₁, x₂}.

For another example, shifting values of positions at which there are second-type edges belongs to {x₁, -x₁, x₂, -x₂}.

For another example, shifting values of positions at which there are second-type edges may be k₁x₁+k₂x₂, where k₁ and k₂ are non-negative integers. Shifting values corresponding to second-type edges at different positions may be the same or different. That is, value combinations of k₁ and k₂ corresponding to the second-type edges at the different positions may be the same or different. For example, the value combinations of k₁ and k₂ include: k₁=3 and k₂=2, k₁=-1 and k₂=0, k₁=1 and k₂=1, and k₁=0 and k₂=-1. Shifting values of positions at which there are second-type edges belongs to {3x₁+2x₂, -x1, x₁+x₂, x₁}.

In the foregoing several examples, elimination methods are changed from simple to complex, with cycle properties gradually improving. During actual implementation, complexity and the cycle properties may be balanced, and an appropriate solution is selected.

For example, t is greater than or equal to 3.

For example, shifting values of positions at which there are second-type edges may be a linear combination of a maximum of two of x₁, x₂, ..., and xₜ, namely, kᵢxᵢ + kⱼxⱼ. Shifting values corresponding to second-type edges at different positions may be the same or different.

In another possible implementation, the second-type edges correspond to two permutations, and shifting values of positions of all edges corresponding to one of the two permutations are all 0. If the shifting values are 0, it indicates that a matrix obtained after the positions are increased based on the lifting size is an identity matrix.

### (3) Shifting value of a position of a third-type edge

In a possible implementation, the shifting value of the position of the third-type edge is not 0.

In another possible implementation, the shifting value of the position of the third-type edge may be determined based on t values, where the t values are all greater than or equal to 0, and t is a positive integer. For specific descriptions, refer to a manner of determining the shifting value of the position of the second-type edge.

### 2. Degree distribution 2

It is assumed that the first square matrix is an m×m matrix, where m is a positive integer. When the first square matrix uses the degree distribution 2, the first square matrix includes m-1 columns having even column weights and one column having an odd column weight, and a row weight of each row in the first square matrix is 2 or 3. The m-1 columns having even column weights include at least one column having an even column weight greater than or equal to 4, and a quantity of rows having row weights being 3 in the first square matrix is 1 plus a quantity of columns having even column weights greater than or equal to 4.

The degree distribution 2 has an advantage of supporting a larger column degree. Therefore, a better decoding threshold is provided, and encoding is easy to implement.

In a possible implementation, the first square matrix includes one column having a column weight being 4, one column having a column weight being 3, and m-2 columns having column weights being 2.

Example 3: The first square matrix is a 4×4 matrix, that is, m=4. Degrees of four columns in the first square matrix are 4, 2, 3, and 2 respectively, and degrees of four rows in the first square matrix are 3, 2, 3, and 3 respectively. In this case, zero elements and non-zero elements in the first square matrix may be distributed as follows: $\left[\begin{matrix}1 & 0 & 1 & 1 \\ 1 & 0 & 1 & 0 \\ 1 & 1 & 1 & 0 \\ 1 & 1 & 0 & 1\end{matrix}\right] ,$ where
"0" represents a zero element, and "1" represents a non-zero element. A specific value (namely, a shifting value) of the non-zero element in the first square matrix is not limited in embodiments of this application. For example, values of the non-zero elements in the first square matrix may be shown in the following matrix: $\left[\begin{matrix}x & - 1 & a & c \\ y & - 1 & a & - 1 \\ x & z & b & - 1 \\ y & z & - 1 & c\end{matrix}\right] ,$ where
"-1" represents a zero element, "x", "y", "z", "a", "b", or "c" represents non-zero elements with respective shifting values of x, y, z, a, b, or c, x ≠ y, a≠ b, x, y, z, a, and c are positive integers, and b is a non-negative integer.

Example 4: The first square matrix is a 5×5 matrix, that is, m=5. Degrees of five columns in the first square matrix are 4, 3, 2, 2, and 2 respectively, and degrees of five rows in the first square matrix are 3, 3, 3, 2, and 2 respectively. In this case, zero elements and non-zero elements in the first square matrix may be distributed as follows: $\left[\begin{matrix}1 & 1 & 1 & 0 & 0 \\ 1 & 0 & 0 & 1 & 1 \\ 1 & 0 & 1 & 1 & 0 \\ 1 & 1 & 0 & 0 & 0 \\ 0 & 1 & 0 & 0 & 1\end{matrix}\right] ,$ where
"0" represents a zero element, and "1" represents a non-zero element. A specific value (namely, a shifting value) of the non-zero element in the first square matrix is not limited in embodiments of this application. For example, values of the non-zero elements in the first square matrix may be shown in the following matrix: $\left[\begin{matrix}x & d & c & - 1 & - 1 \\ x & - 1 & - 1 & p & a \\ y & - 1 & c & p & - 1 \\ y & d & - 1 & - 1 & - 1 \\ - 1 & b & - 1 & - 1 & a\end{matrix}\right] ,$ where
"-1" represents a zero element, "x", "y", "a", "b", "c", "d", or "p" represents non-zero elements with respective shifting values of x, y, a, b, c, d, or p, x ≠ y, b≠ d, x, y, a, p, c, and d are positive integers, and b is a non-negative integer.

In a possible implementation, the first square matrix includes two columns having column weights being 4, one column having a column weight being 3, and m-3 columns having column weights being 2.

Example 5: The first square matrix is a 5×5 matrix, that is, m=5. Degrees of five columns in the first square matrix are 4, 3, 2, 2, and 4 respectively, and degrees of five rows in the first square matrix are 3, 3, 4, 3, and 2 respectively. In this case, zero elements and non-zero elements in the first square matrix may be distributed as follows: $\left[\begin{matrix}1 & 1 & 1 & 0 & 0 \\ 1 & 0 & 0 & 1 & 1 \\ 1 & 0 & 1 & 1 & 1 \\ 1 & 1 & 0 & 0 & 1 \\ 0 & 1 & 0 & 0 & 1\end{matrix}\right] ,$ where
"0" represents a zero element, and "1" represents a non-zero element. A specific value (namely, a shifting value) of the non-zero element in the first square matrix is not limited in embodiments of this application. For example, values of the non-zero elements in the first square matrix may be shown in the following matrix: $\left[\begin{matrix}x & d & c & - 1 & - 1 \\ x & - 1 & - 1 & p & a \\ y & - 1 & c & p & e \\ y & d & - 1 & - 1 & a \\ - 1 & b & - 1 & - 1 & a\end{matrix}\right] ,$ where
"-1" represents a zero element, "x", "y", "a", "b", "c", "d", "e", or "p" represents non-zero elements with respective shifting values of x, y, a, b, c, d, e, or p, x ≠ y, b≠ d, a≠ e, x, y, a, p, c, d, and e are positive integers, and b is a non-negative integer.

It should be noted that a manner of obtaining the values of the non-zero elements in the first square matrix shown in the foregoing matrix is merely an example. Generalized descriptions may be provided below.
(1) Each column in the first square matrix has at least one value of x, y, z, a, c, d, e, or p, and a quantity of times that a value appears in the column is an even number. For example, x, y, z, a, c, d, e, and p each appear twice in the foregoing matrix.
(2) Different letters in a same column represent different shifting values, and different letters in different columns represent a same shifting value or different shifting values.
(3) It is assumed that row sets in which x, y, z, a, c, d, e, and p are present are Rₓ, R_{y}, R*_{z}*, R*ₐ*, R_{c}, R_{d}, Rₑ, and Rₚ respectively, an intersection between any two of these row sets includes a maximum of one element. Specifically, an intersection between row sets corresponding to different letters in different columns includes one element, for example, Rₓ = {1,2} and R*ₐ* = {2,5} in Example 4, and an intersection between Rₓ and R*ₐ* is {2}. An intersection set of row sets corresponding to different letters in a same column is an empty set, for example, Rₓ = {1,2} and R*_{y}* = {3,4} in Example 4, and an intersection between Rₓ and R*_{y}* is an empty set.
(4) A column weight of a column in which b is located is an odd number, and the column intersects at least one row whose row weight is 2. For example, in Example 4, b is in a 2^{nd} column, and the 2^{nd} column intersects a 4^{th} row and a 5^{th} row whose row weights are 2. In addition, if the column intersects only one row whose row weight is 2, another column that intersects the row whose row weight is 2 and the column jointly intersect a row whose row weight is 3. For example, in Example 3, b is in a 3^{rd} column, the 3^{rd} column intersects a 2^{nd} row whose row weight is 2, another column that intersects the 2^{nd} row is a 1^{st} column, and the 3^{rd} column and the 1^{st} column jointly intersect a 3^{rd} row whose row weight is 3. For another example, in Example X, b is in a 2^{nd} column, the 2^{nd} column intersects a 5^{th} row whose row weight is 2, another column that intersects the 5^{th} row is a 5^{th} column, and the 2^{nd} column and the 5^{th} column jointly intersect a 4^{th} row whose row weight is 3.

### 3. Degree distribution 3

It is assumed that the first square matrix is an m×m matrix, where m is a positive integer. When the first square matrix uses the degree distribution 3, a column weight of each column in the first square matrix is 2 or 3, a quantity of columns having column weights being 3 in the first square matrix is greater than or equal to 2, and a quantity of columns having column weights being 2 in the first square matrix is greater than 0.

In a possible implementation, the quantity of columns having column weights being 2 in the first square matrix is an even number.

In another possible implementation, the first square matrix includes two columns having column weights being 2 and m-2 columns having column weights being 3.

In another possible implementation, m is an even number greater than 0, and the first square matrix includes m-2 columns having column weights being 2 and two columns having column weights being 3.

In another possible implementation, m is an odd number greater than 0, and the first square matrix includes m-3 columns having column weights being 2 and three columns having column weights being 3.

Example 6: The first square matrix is a 4×4 matrix, that is, m=4. Degrees of four columns in the first square matrix are 3, 3, 2, and 2 respectively, and degrees of four rows in the first square matrix are 3, 3, 2, and 2 respectively. In this case, zero elements and non-zero elements in the first square matrix may be distributed as follows: $\left[\begin{matrix}1 & 1 & 1 & 0 \\ 1 & 1 & 0 & 1 \\ 1 & 0 & 0 & 1 \\ 0 & 1 & 1 & 0\end{matrix}\right] ,$ where
"0" represents a zero element, and "1" represents a non-zero element. In the distribution of the zero elements and the non-zero elements, two rows are completely orthogonal, that is, columns associated with the two rows do not overlap. For example, a 3^{rd} row and a 4^{th} row in the matrix are completely orthogonal. A specific value (namely, a shifting value) of the non-zero element in the first square matrix is not limited in embodiments of this application. For example, values of the non-zero elements in the first square matrix may be shown in any one of the following matrices: $\left[\begin{matrix}0 & 0 & 0 & - 1 \\ 0 & x & - 1 & 0 \\ 0 & - 1 & - 1 & x \\ - 1 & 0 & - x & - 1\end{matrix}\right] , \left[\begin{matrix}0 & 0 & 0 & - 1 \\ 0 & x & - 1 & 0 \\ 0 & - 1 & - 1 & - x \\ - 1 & 0 & x & - 1\end{matrix}\right] , \left[\begin{matrix}0 & 0 & 0 & - 1 \\ 0 & - 2 x & - 1 & 0 \\ 0 & - 1 & - 1 & x \\ - 1 & 0 & x & - 1\end{matrix}\right] , \left[\begin{matrix}0 & 0 & 0 & - 1 \\ 0 & - 1 & - 1 & 0 \\ 0 & - 1 & x & - x \\ - 1 & 0 & x & - 1\end{matrix}\right] ,$ $\left[\begin{matrix}0 & 0 & 0 & - 1 \\ 0 & - 1 & - 1 & 0 \\ 0 & - 1 & x & 2 x \\ - 1 & 0 & x & - 1\end{matrix}\right] , \left[\begin{matrix}0 & 0 & 0 & - 1 \\ 0 & - 1 & - 1 & 0 \\ 0 & - 1 & x & x \\ - 1 & 0 & - x & - 1\end{matrix}\right] , \left[\begin{matrix}0 & 0 & 0 & - 1 \\ 0 & - 1 & - 1 & 0 \\ 0 & - 1 & 2 x & x \\ - 1 & 0 & x & - 1\end{matrix}\right] , \left[\begin{matrix}0 & 0 & 0 & - 1 \\ 0 & x & - 1 & 0 \\ 0 & - 1 & x & - 1 \\ - 1 & 0 & - 1 & - x\end{matrix}\right] ,$ $\left[\begin{matrix}0 & 0 & 0 & - 1 \\ 0 & x & - 1 & 0 \\ 0 & - 1 & x & - 1 \\ - 1 & 0 & - 1 & - 2 x\end{matrix}\right] , or \left[\begin{matrix}0 & 0 & 0 & - 1 \\ 0 & x & - 1 & 0 \\ 0 & - 1 & - x & - 1 \\ - 1 & 0 & - 1 & 0\end{matrix}\right] ,$ where
"-1" represents a zero element, "0" represents a non-zero element with a shifting value of 0, "x" represents a non-zero element with a shifting value of x, "-x" represents a non-zero element with a shifting value of Z_{c}-x, "2x" represents a non-zero element with a shifting value of 2x, "-2x" represents a non-zero element with a shifting value of Z_{c}-2x, Z_{c} is a lifting size, and x is a positive integer. It can be learned from the foregoing matrices that shifting values of non-zero elements in the first row and the first column are all 0, each matrix has only one unknown number x with a variable value, and values of all other positions are determined based on the unknown number. The value of x may be any positive integer, and usually ranges from 1 to Z_{c}-1.

Example 7: The first square matrix is a 5×5 matrix, that is, m=5. Degrees of five columns in the first square matrix are 3, 3, 3, 2, and 2 respectively, and degrees of five rows in the first square matrix are 3, 3, 3, 2, and 2 respectively. In this case, zero elements and non-zero elements in the first square matrix may be distributed as follows: $\left[\begin{matrix}1 & 1 & 1 & 0 & 0 \\ 1 & 0 & 0 & 1 & 1 \\ 1 & 0 & 1 & 1 & 0 \\ 0 & 1 & 1 & 0 & 0 \\ 0 & 1 & 0 & 0 & 1\end{matrix}\right] ,$ where
"0" represents a zero element, and "1" represents a non-zero element. A specific value (namely, a shifting value) of the non-zero element in the first square matrix is not limited in embodiments of this application. For example, values of the non-zero elements in the first square matrix may be shown in any one of the following matrices: $\left[\begin{matrix}0 & 0 & 0 & - 1 & - 1 \\ 0 & - 1 & - 1 & 0 & 0 \\ 0 & - 1 & z & - z & - 1 \\ - 1 & 0 & z & - 1 & - 1 \\ - 1 & 0 & - 1 & - 1 & x\end{matrix}\right] , \left[\begin{matrix}0 & 0 & 0 & - 1 & - 1 \\ 0 & - 1 & - 1 & 0 & 0 \\ 0 & - 1 & - 1 & x & - 1 \\ - 1 & 0 & - 1 & 0 & - 1 \\ - 1 & 0 & x & - 1 & 0\end{matrix}\right] ,$ or $\left[\begin{matrix}0 & 0 & 0 & - 1 & - 1 \\ 0 & - 1 & - 1 & 0 & 0 \\ 0 & - 1 & x & - 1 & - 1 \\ - 1 & 0 & - 1 & 0 & x \\ - 1 & 0 & - 1 & - 1 & 0\end{matrix}\right] ,$ where
"-1" represents a zero element, "0" represents a non-zero element with a shifting value of 0, "x" represents a non-zero element with a shifting value of x, "-x" represents a non-zero element with a shifting value of Z_{c}-x, "z" represents a non-zero element with a shifting value of z, "-z" represents a non-zero element with a shifting value of Z_{c}-z, Z_{c} is a lifting size, and x and z are positive integers.

Example 8: The first square matrix is a 5×5 matrix, that is, m=5. Degrees of five columns in the first square matrix are 3, 3, 3, 3, and 2 respectively, and degrees of five rows in the first square matrix are 3, 3, 3, 3, and 2 respectively. In this case, zero elements and non-zero elements in the first square matrix may be distributed as follows: $\left[\begin{matrix}1 & 1 & 1 & 0 & 0 \\ 1 & 0 & 0 & 1 & 1 \\ 1 & 0 & 1 & 1 & 0 \\ 0 & 1 & 1 & 0 & 0 \\ 0 & 1 & 0 & 1 & 1\end{matrix}\right] ,$ where
"0" represents a zero element, and "1" represents a non-zero element. A specific value (namely, a shifting value) of the non-zero element in the first square matrix is not limited in embodiments of this application. For example, values of the non-zero elements in the first square matrix may be shown in the following matrix: $\left[\begin{matrix}0 & 0 & 0 & - 1 & - 1 \\ 0 & - 1 & - 1 & 0 & 0 \\ 0 & - 1 & z & - z & - 1 \\ - 1 & 0 & z & - 1 & x \\ - 1 & 0 & - 1 & x & - 1\end{matrix}\right] ,$ where
"-1" represents a zero element, "0" represents a non-zero element with a shifting value of 0, "x" represents a non-zero element with a shifting value of x, "z" represents a non-zero element with a shifting value of z, "-z" represents a non-zero element with a shifting value of Z_{c}-z, Z_{c} is a lifting size, and x and z are positive integers.

It should be noted that a manner of storing the shifting values of the non-zero elements is not limited in embodiments of this application. For example, a rule may be stored, and a stored value may be a value obtained by performing a modulo (namely, remainder) operation. The modulo operation is performed on a lifting size during use; or a value obtained by performing the modulo operation on a maximum lifting size may be stored. This is not limited.

It should be further noted that, due to a basic feature of the LDPC code, equivalent matrices obtained by performing a row permutation order and/or a column permutation order on the matrices listed in the foregoing examples (for example, Example 1 to Example 7) also falls within the scope of embodiments of this application. Equivalent matrices obtained by adding an integer to all values of non-zero elements in an entire row and/or an entire column (for example, adding 1 to all values of non-zero elements in a first row or adding 2 to all values of non-zero elements in a first row) in the matrices listed above also falls within the scope of embodiments of this application.

In some other embodiments of this application, the first matrix region, namely, the region B, may further include at least one second square matrix. The first square matrix does not overlap the at least one second square matrix, and a second sub-region including the first square matrix and the at least one second square matrix includes all diagonal elements in the first matrix region. A size of the second square matrix is not limited in embodiments of this application. The second square matrix may include one or more elements.

Specifically, the region B may include a plurality of blocks, and an i^{th} block in the plurality of blocks includes an (rᵢ + 1)^{th} row to an rᵢ₊₁^{th} row and an (rᵢ + 1 + k₀)^{th} column to an (rᵢ₊₁ + k₀)^{th} column in the LDPC base matrix, where k₀ is a quantity of information columns, r₁ = 0, and i is an integer greater than 1. A quantity of values of i corresponds to a quantity of the plurality of blocks. It can be learned that the plurality of blocks do not overlap and are all square matrices, and the plurality of blocks include all diagonal elements in the region B. The plurality of blocks correspond to the first square matrix and the at least one second square matrix.

FIG. 13 shows an example of a block included in the region B. In FIG. 13, an example in which the region B includes two blocks: a block 1 and a block 2 is used. In other words, the region B includes a first square matrix and one second square matrix.

FIG. 14A and FIG. 14B each show a specific example of a block included in the region B.

In FIG. 14A and FIG. 14B, "-1" represents a zero element, "0" represents a non-zero element with a shifting value of 0, "x" represents a non-zero element with a shifting value of x, "y" represents a non-zero element with a shifting value of y, "z" represents a non-zero element with a shifting value of z, "-z" represents a non-zero element with a shifting value of Z_{c}-z, Z_{c} is a lifting size, and x, y, and z are positive integers.

As shown in FIG. 14A and FIG. 14B, a 1^{st} row to a 5^{th} row and a 1^{st} column to a 5^{th} column in the region B are a first block, and a 6^{th} row and a 6^{th} column are a second block. A degree distribution of the first block is the degree distribution 3 described above, the second block has only one element, and the element is a non-zero element. The region B shown in FIG. 4B also meets the degree distribution 3 as a whole.

In embodiments of this application, a distribution of zero elements and non-zero elements and shifting values of the non-zero elements in a region outside the first block and the second block are not limited, and may be shown in FIG. 14A or FIG. 14B, or may be in other forms.

The following describes a distribution of zero elements and non-zero elements in a region outside the plurality of blocks by using an *i*^{th} block and an (i + 1)^{th} block as an example. The following descriptions are applicable to any i.

In a possible implementation, elements in a region outside the *i*^{th} block and the (i *+* 1)^{th} block are all zero elements. This structure has an advantage of encoding the *i*^{th} block and the (i + 1)^{th} block completely in parallel, thereby increasing an encoding rate.

In another possible implementation, the distribution may be a lower triangular structure. To be specific, all elements in an (rᵢ + 1)^{th} row to an rᵢ₊₁^{th} row and an(r_{*i*+1} + 1 + k₀)^{th} column to an (*r*_{*i*+2} + k₀)^{th} column are zero elements, and an (*r*_{*i*+1} + 1)^{th} row to an *r*_{*i+*2}^{th} row and an (*rᵢ +* 1 + k₀)^{th} column to an (r_{*i*+1} + k₀)^{th} column may include non-zero elements. This structure has an advantage of supporting a more flexible degree distribution, thereby helping improve a threshold for decoding the LDPC code.

In another possible implementation, the distribution may be an upper triangular structure. To be specific, an (rᵢ + 1)^{th} row to an rᵢ₊₁^{th} row and an (*r*_{*i*+1} + 1 + k₀)^{th} column to an *(r*_{*i+*2} + k₀)^{th} column include non-zero elements, and elements in an (*r*_{*i*+1} + 1)^{th} row to an *r*_{*i*+2}^{th} row and an (*rᵢ* + 1 + k₀)^{th} column to an (*r*_{*i*+1} + k₀)^{th} column are all zero elements. This structure has an advantage of supporting a more flexible degree distribution, thereby helping improve a threshold for decoding the LDPC code.

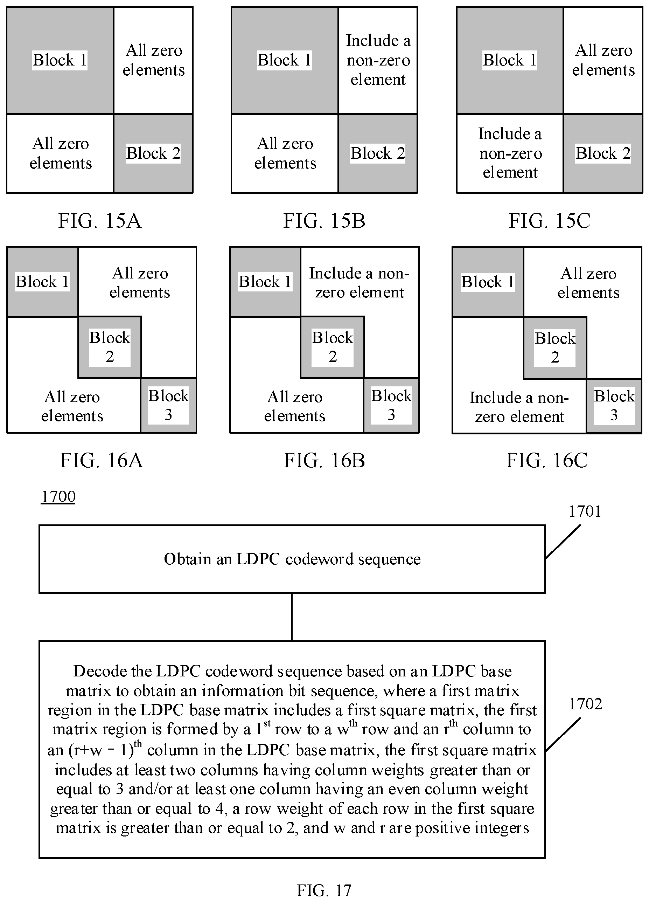

FIG. 15A to FIG. 15C each show another example of the region B. In FIG. 15A to FIG. 15C, the region B includes two blocks: a block 1 and a block 2.

As shown in FIG. 15A, there are all zero elements in a region outside the block 1 and the block 2. As shown in FIG. 15B, a region that is outside the block 1 and the block 2 and that is in an upper right corner of the region B includes a non-zero element, and there are all zero elements in a region that is outside the block 1 and the block 2 and that is in a lower left corner of the region B. As shown in FIG. 15C, there are all zero elements in a region that is outside the block 1 and the block 2 and that is in an upper right corner of the region B, and a region that is outside the block 1 and the block 2 and that is in a lower left corner of the region B includes a non-zero element.

The foregoing descriptions are provided by using two adjacent blocks as an example. Actually, the foregoing descriptions may be applicable to a case in which there are more adjacent blocks, for example, a case in which there are three adjacent blocks: an *i*^{th} block, an (i + 1)^{th} block, and an (i + 2)^{th} block.

FIG. 16A to FIG. 16C each show another example of the region B. In FIG. 16A to FIG. 16C, the region B includes three blocks: a block 1, a block 2, and a block 3.

As shown in FIG. 16A, there are all zero elements in a region outside the block 1, the block 2, and the block 3. As shown in FIG. 16B, a region that is outside the block 1, the block 2, and the block 3 and that is in an upper right corner of the region B includes a non-zero element, and there are all zero elements in a region that is outside the block 1, the block 2, and the block 3 and that is in a lower left corner of the region B. As shown in FIG. 16C, there are all zero elements in a region that is outside the block 1, the block 2, and the block 3 and that is in an upper right corner of the region B, and a region that is outside the block 1, the block 2, and the block 3 and that is in a lower left corner of the region B includes a non-zero element.

Based on the foregoing content, zero elements and non-zero elements in a region other than the first sub-region including the first square matrix and the at least one second square matrix may be distributed as follows: Elements in an upper right part of the first sub-region are all zero elements, and elements in a lower left part of the first sub-region are all zero elements; or elements in an upper right part of the first sub-region are all zero elements, and a region in a lower left part of the first sub-region includes a non-zero element; or a region in an upper right part of the first sub-region includes a non-zero element, and elements in a lower left part of the first sub-region are all zero elements.

A degree distribution structure or an encoding structure used by the at least one second square matrix is not limited in this application. The at least one second square matrix all may use the degree distributions provided in embodiments of this application, or a part or all of the at least one second square matrix may use another degree distribution (for example, the dual-diagonal structure, the diagonal structure, the upper triangular structure, or the lower triangular structure).

In a possible implementation, when only the first square matrix in the region B uses the degree distributions in embodiments of this application, in other words, when none of the at least one second square matrix uses the degree distributions in embodiments of this application, the first square matrix is located in an upper left corner of the region B (that is, the first square matrix is a block with a smallest number), a region in the upper right part of the first sub-region includes a non-zero element, and elements in a lower left part of the first sub-region are all zero elements.

In another possible implementation, when only the first square matrix in the region B uses the degree distributions in embodiments of this application, in other words, when none of the at least one second square matrix uses the degree distributions in embodiments of this application, the first square matrix is located in a lower right corner of the region B (that is, the first square matrix is a block with a largest number), elements in an upper right part of the first sub-region are all zero elements, and a region in a lower left part of the first sub-region includes a non-zero element.

In the foregoing two implementations, the first square matrix may use the degree distribution 1. This solution has an advantage of implementing a column degree of a coding structure of at least 3 while simplifying encoding, thereby helping ensure a property that the code distance of the LDPC code linearly increases with the code length.

It should be noted that the orientations such as the lower left corner and the upper right corner mentioned above are described relative to the LDPC base matrix or the first matrix region, and are relative directions.

Embodiments of this application focus on improving the region B in the LDPC base matrix, that is, improving the encoding structure of the LDPC base matrix. A structure and a feature of a region other than the region B in the LDPC base matrix are not limited.

In a possible implementation, when the region B is a 3-regular edge, column weights of all columns in the region A are 3 or more. More specifically, column weights of all columns in the region A are 3. Alternatively, when there are punctured columns, a column weight of at least one column in the punctured columns is greater than 3, and column weights of remaining columns are all 3. In terms of row weights, row weights of rows in the region A are the same, or a difference between the row weights of the rows is at most 1.

In another possible implementation, when the region B is the degree distribution 2 or the degree distribution 3, row weights of rows in the A region are non-uniform, and a difference between the row weights of the rows is 1 or 2.

FIG. 17 is a schematic flowchart of an LDPC code-based communication method 1700 according to this application.

The method 1700 may be performed by a receiver device. Unless otherwise specified, the "receiver device" may be a receiver device, or may be an apparatus that can support a receiver device in implementing a function of the receiver device. For ease of description, the receiver device is used below for description. The receiver device may be a terminal device or a network device.

The method 1700 may include at least a part of the following content.

Step 1701: The receiver device obtains an LDPC codeword sequence.

That the receiver device obtains the LDPC codeword sequence may mean that the receiver device obtains the LDPC codeword sequence from a memory, where the LDPC codeword sequence may be an LDPC codeword sequence obtained by the receiver device based on an air interface signal from a transmitter device. That the receiver device obtains the LDPC codeword sequence may alternatively mean that the receiver device receives an air interface signal from a transmitter device, and obtains the LDPC codeword sequence based on the air interface signal.

Step 1702: The receiver device decodes the LDPC codeword sequence based on an LDPC base matrix, to obtain an information bit sequence.

It should be noted that because a channel noise signal may be introduced in a transmission process of an air interface signal, the air interface signal output or sent by the transmitter device may be different from the air interface signal received by the receiver device, and the LDPC codeword sequence obtained based on the air interface signal may be different from the LDPC codeword sequence output by the transmitter device.

Similarly, the LDPC base matrix may be a base matrix stored in the receiver device or a base matrix predefined in a protocol, or may be a base matrix further obtained based on a stored base matrix or a base matrix predefined in a protocol. This is not limited. For the LDPC base matrix in the method 1700, refer to related descriptions of the transmitter device. Details are not described herein again.

The following describes performance of the LDPC code in embodiments of this application with reference to simulation results.

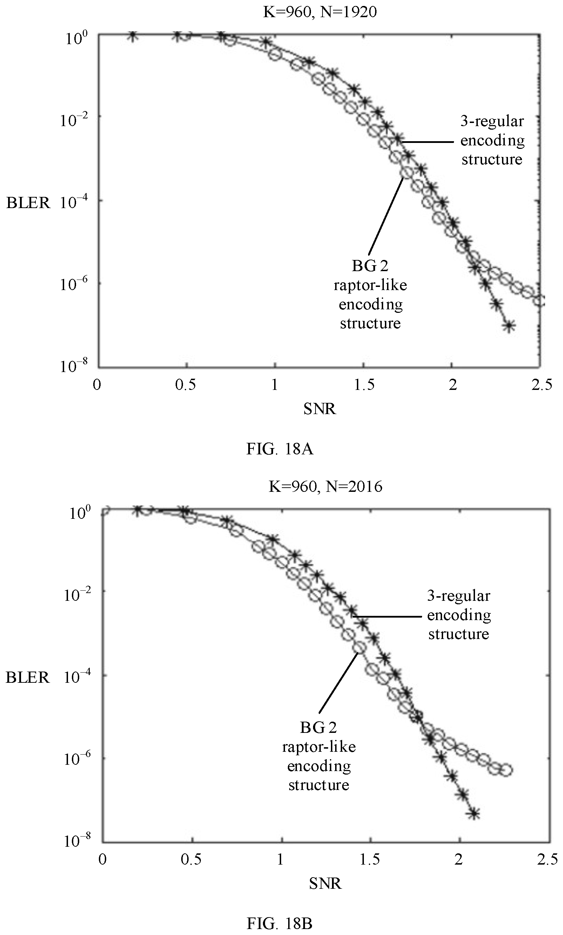

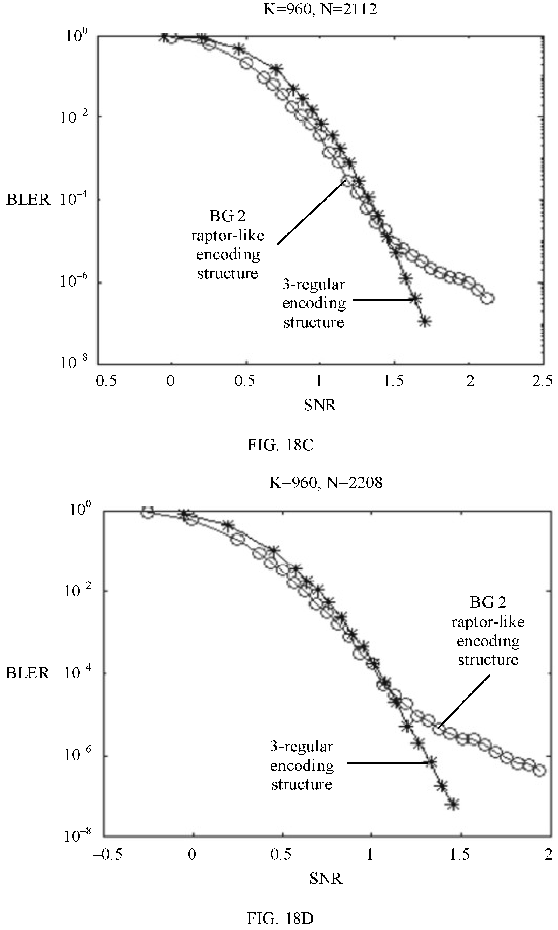

FIG. 18A to FIG. 18D show simulation results of SNRs of a BG 2 raptor-like encoding structure and a 3-regular encoding structure of this application at different code lengths and different BLERs.

A high-reliability and low-latency scenario (for example, a URLLC scenario) has a high requirement on reliability. A degree distribution of the BG 2 raptor-like encoding structure is not conducive to a linear increase of a code distance with a code length. When a BLER decreases, a severe error floor occurs. The 3-regular encoding structure (namely, 3-regular degree distribution) of this application can be used to increase a degree of a check node, and provide a more flexible encoding structure, thereby helping reduce the error floor. As shown in FIG. 18A to FIG. 18D, no error floor occurs until the BLER is less than 1e-7, and the 3-regular encoding structure has a performance gain of approximately 0.5 dB at 1e-7 compared with the BG2 raptor-like encoding structure.

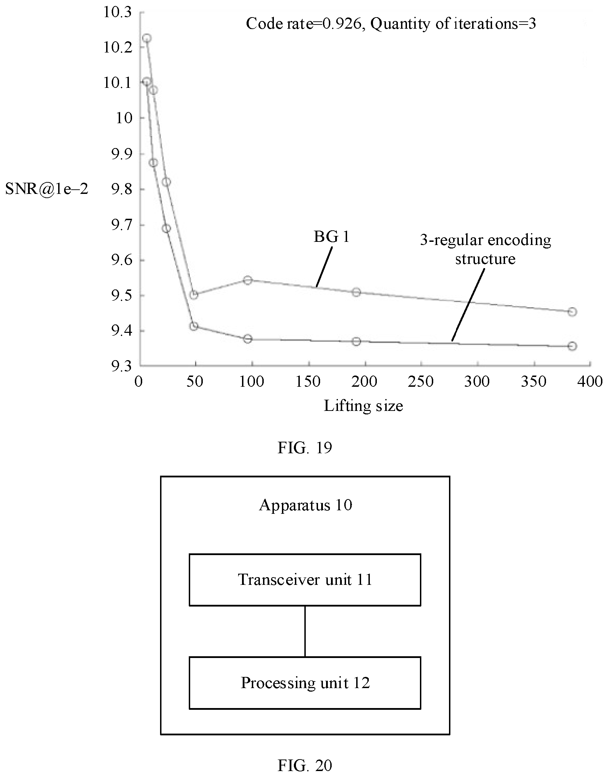

FIG. 19 shows simulation results of SNRs of a BG 1 dual-diagonal encoding structure and a 3-regular encoding structure of this application at different lifting sizes.

FIG. 19 shows simulation results of SNRs at different lifting sizes in a case in which a code rate is 0.926 and a quantity of iterations is 3. A high-throughput scenario has a high requirement on a convergence speed. Compared with the BG 1 dual-diagonal encoding structure, the 3-regular encoding structure (namely, 3-regular degree distribution) of this application can be used to improve an overall edge density, thereby improving the convergence speed. In a scenario in which a peak code rate exceeds a code rate of a kernel matrix, kernel parity columns need to be punctured, and a kernel parity column with a larger column degree can bring a performance gain.

In this way, based on the encoding structure provided in this embodiment of this application, encoding may be performed through QC-level Gaussian elimination, and a degree distribution is more flexible, to meet requirements in different communication scenarios. For example, in a high-reliability and low-latency scenario (for example, a URLLC scenario), the encoding structures provided in embodiments of this application can be used to implement decoupling between 2-degree nodes, a minimum trapping set is larger, and simple encoding can still be implemented when a scale of the encoding structure is larger. For another example, in a high-throughput scenario, the encoding structures provided in embodiments of this application can provide a larger column weight, thereby helping implement fast convergence.

The foregoing describes the method embodiments provided in this application in detail with reference to FIG. 7 to FIG. 19. The following describes apparatus embodiments of this application with reference to FIG. 20 to FIG. 22.

It may be understood that, to implement functions in the foregoing embodiments, apparatuses in FIG. 20 to FIG. 22 includes a corresponding hardware structure and/or software module for performing the functions. A person skilled in the art should be easily aware that, in combination with the units and the method steps in the examples described in embodiments disclosed in this application, this application can be implemented by hardware or a combination of hardware and computer software.

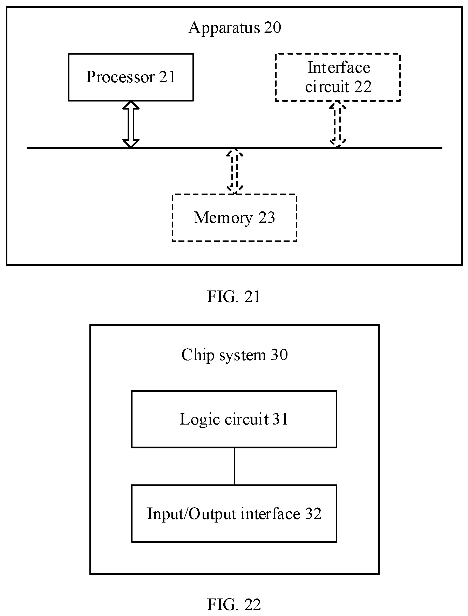

FIG. 20 and FIG. 21 each are a diagram of a structure of a possible apparatus according to an embodiment of this application. These apparatuses may be configured to implement functions of the transmitter device or the receiver device in the foregoing method embodiments. Therefore, beneficial effect of the foregoing method embodiments can also be implemented.

As shown in FIG. 20, an apparatus 10 includes a transceiver unit 11 and a processing unit 12.

When the apparatus 10 is configured to implement a function of the transmitter device in the foregoing method embodiments, the transceiver unit 11 is configured to perform sending and receiving steps of the transmitter device, for example, step 701 and step 703, and the processing unit 12 is configured to perform the processing step 702 of the transmitter device. When the apparatus 10 is configured to implement a function of the receiver device in the foregoing method embodiments, the transceiver unit 11 is configured to perform sending and receiving steps of the receiver device, for example, step 1701, and the processing unit 12 is configured to perform a processing step of the receiver device, for example, step 1702.

For more detailed descriptions of the transceiver unit 11 and the processing unit 12, refer to the related descriptions in the foregoing method embodiments. Details are not described herein again.

As shown in FIG. 21, an apparatus 20 includes a processing circuit 21. The processing circuit 21 is coupled to a memory 23. The memory 23 is configured to store instructions. When the apparatus 20 is configured to implement the foregoing methods, the processing circuit 21 is configured to execute the instructions in the memory 23, to implement a function of the processing unit 12.

Optionally, the apparatus 20 further includes the memory 23.

Optionally, the apparatus 20 further includes a transceiver circuit 22. The transceiver circuit may be referred to as a communication interface. The processing circuit 21 and the transceiver circuit 22 are coupled to each other. It may be understood that the transceiver circuit 22 may be a transceiver or an input/output interface. When the apparatus 20 is configured to implement the foregoing methods, the processing circuit 21 is configured to execute the instructions to implement a function of the processing unit 12, and the transceiver circuit 22 is configured to implement a function of the transceiver unit 11.

Optionally, the apparatus 20 may be the transmitter device or the receiver device, and correspondingly, the transceiver circuit may be a transceiver.

Optionally, the apparatus 20 may be a chip used in the transmitter device or the receiver device, and correspondingly, the transceiver circuit may be an input/output interface.

For example, when the apparatus 20 is a chip used in the transmitter device or the receiver device, the chip implements a function of the transmitter device or the receiver device in the foregoing method embodiments. The chip receives information from another module (for example, a radio frequency module or an antenna) in the transmitter device or the receiver device, where the information is sent by another apparatus to the transmitter device or the receiver device; or the chip sends information to another module (for example, a radio frequency module or an antenna) in the transmitter device or the receiver device, where the information is sent by the transmitter device or the receiver device to another apparatus.

FIG. 22 is a diagram of a chip system 30 according to an embodiment of this application. The chip system 30 (or may be referred to as a processing system) includes a logic circuit 31 and an input/output interface (input/output interface) 32.

The logic circuit 31 may be a processing circuit in the chip system 30. The logic circuit 31 may be coupled to a storage unit, and invoke instructions in the storage unit, so that the chip system 30 can implement the methods and functions in embodiments of this application. The input/output interface 32 may be an input/output circuit in the chip system 30, and outputs information processed by the chip system 30, or inputs to-be-processed data or signaling information into the chip system 30 for processing.

In a solution, the chip system 30 is configured to implement the operations performed by the transmitter device or the receiver device in the foregoing method embodiments.

For example, the logic circuit 31 is configured to implement processing-related operations performed by the transmitter device or the receiver device in the foregoing method embodiments. The input/output interface 32 is configured to implement a sending-related operation and/or a receiving-related operation performed by the transmitter device or the receiver device in the foregoing method embodiments.

This application further provides a communication apparatus, including a processing circuit. The processing circuit is coupled to a memory. The memory is configured to store a computer program or instructions and/or data. The processing circuit is configured to execute the computer program or the instructions stored in the memory, or read the data stored in the memory, to perform the methods in the foregoing method embodiments. Optionally, there are one or more processing circuits. Optionally, the communication apparatus includes the memory. Optionally, there are one or more memories. Optionally, the memory and the processing circuit are integrated together or disposed separately.

This application further provides a chip, including a processing circuit. The processing circuit is coupled to a memory. The memory is configured to store a computer program or instructions. The processing circuit is configured to execute the computer program or the instructions stored in the memory, to implement the method performed by the transmitter device or the receiver device in the foregoing method embodiments. The memory may be located in the chip, or may be independent of the chip and located outside the chip. This is not limited herein.

This application further provides a computer-readable storage medium. The computer-readable storage medium stores computer instructions for implementing the method performed by the transmitter device or the receiver device in the foregoing method embodiments.

This application further provides a computer program product, including instructions. When the instructions are executed by a computer, the method performed by the transmitter device or the receiver device in the foregoing method embodiments is implemented.

This application further provides a communication system. The communication system includes at least one of the transmitter device or the receiver device in the foregoing embodiments.

For explanations and beneficial effect of related content in any one of the apparatuses provided above, refer to the corresponding method embodiments provided above. Details are not described herein again.

It may be understood that the processing circuit in embodiments of this application may be a processor or a circuit configured to perform a processing operation in a processor. The processor may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a transistor logic device, a hardware component, or any combination thereof. The general-purpose processor may be a microprocessor or any regular processor.

The method steps in embodiments of this application may be implemented in a hardware manner, or may be implemented in a manner of executing software instructions by the processor. The software instructions may include a corresponding software module. The software module may be stored in a random access memory, a flash memory, a read-only memory, a programmable read-only memory, an erasable programmable read-only memory, an electrically erasable programmable read-only memory, a register, a hard disk, a removable hard disk, a compact disc read-only memory (compact disc read-only memory, CD-ROM), or any other form of storage medium well-known in the art. For example, a storage medium is coupled to the processor, so that the processor can read information from the storage medium and write information into the storage medium. Certainly, the storage medium may be a component of the processor. The processor and the storage medium may be disposed in an ASIC. In addition, the ASIC may be located in a transmitter device or a receiver device. Certainly, the processor and the storage medium may alternatively exist in the transmitter device or the receiver device as discrete components.

All or some of the foregoing embodiments may be implemented by using software, hardware, firmware or any combination thereof. When software is used for implementation, all or some of embodiments may be implemented in a form of a computer program product. The computer program product includes one or more computer programs or instructions. When the computer programs or instructions are loaded and executed on a computer, all or some of the procedures or functions in embodiments of this application are executed. The computer may be a general-purpose computer, a dedicated computer, a computer network, a network device, user equipment, or another programmable apparatus. The computer programs or the instructions may be stored in a computer-readable storage medium, or may be transmitted from a computer-readable storage medium to another computer-readable storage medium. For example, the computer programs or the instructions may be transmitted from a website, computer, server, or data center to another website, computer, server, or data center in a wired or wireless manner. The computer-readable storage medium may be any usable medium accessible by the computer, or a data storage device, for example, a server or a data center, integrating one or more usable media. The usable medium may be a magnetic medium, for example, a floppy disk, a hard disk, or a magnetic tape; or may be an optical medium, for example, a digital video disc; or may be a semiconductor medium, for example, a solid-state drive.

In various embodiments of this application, unless otherwise stated or there is a logic conflict, terms and/or descriptions in different embodiments are consistent and may be mutually referenced, and technical features in different embodiments may be combined into a new embodiment based on an internal logical relationship thereof.

Unless otherwise stated, meanings of all technical and scientific terms used in embodiments of this application are the same as those usually understood by a person skilled in the technical field of this application. The terms used in this application are merely intended to describe specific embodiments, and are not intended to limit the scope of this application. It should be understood that the foregoing descriptions are examples for description, and the foregoing examples are merely intended to help a person skilled in the art understand embodiments of this application, but are not intended to limit embodiments of this application to examples of specific values or specific scenarios. It is clear that a person skilled in the art can make various equivalent modifications or variations based on the examples provided above, and such modifications and variations also fall within the scope of embodiments of this application.

## Claims

1. A low-density parity check LDPC code-based communication method, wherein the method comprises:
obtaining an information bit sequence;
performing LDPC encoding on the information bit sequence based on an LDPC base matrix to obtain an LDPC codeword sequence, wherein a first matrix region in the LDPC base matrix comprises a first square matrix, the first matrix region is formed by a 1^{st} row to a w^{th} row and an r^{th} column to an (r+w-1)^{th} column in the LDPC base matrix, the first square matrix comprises at least two columns having column weights greater than or equal to 3 and/or at least one column having an even column weight greater than or equal to 4, a row weight of each row in the first square matrix is greater than or equal to 2, and w and r are positive integers; and
outputting the LDPC codeword sequence.

2. A low-density parity check LDPC code-based communication method, wherein the method comprises:
obtaining an LDPC codeword sequence; and
decoding the LDPC codeword sequence based on an LDPC base matrix to obtain an information bit sequence, wherein a first matrix region in the LDPC base matrix comprises a first square matrix, the first matrix region is formed by a 1^{st} row to a w^{th} row and an r^{th} column to an (r+w-1)^{th} column in the LDPC base matrix, the first square matrix comprises at least two columns having column weights greater than or equal to 3 and/or at least one column having an even column weight greater than or equal to 4, a row weight of each row in the first square matrix is greater than or equal to 2, and w and r are positive integers.

3. The method according to claim 1 or 2, wherein
the first square matrix is an m×m matrix, and m is a positive integer; and
the first square matrix comprises m-1 columns having even column weights and one column having an odd column weight, a row weight of each row in the first square matrix is 2 or 3, a quantity of rows having row weights being 3 in the first square matrix is 1 plus a quantity of the at least one column having an even column weight greater than or equal to 4, and the m-1 columns having even column weights comprise the at least one column having an even column weight greater than or equal to 4.

4. The method according to claim 3, wherein
the first square matrix comprises one column having a column weight being 4, one column having a column weight being 3, and m-2 columns having column weights being 2.

5. The method according to claim 3 or 4, wherein
m=4, and the first square matrix is: $\left[\begin{matrix}x & - 1 & a & c \\ y & - 1 & a & - 1 \\ x & z & b & - 1 \\ y & z & - 1 & c\end{matrix}\right] ,$ wherein
"-1" represents a zero element, "x", "y", "z", "a", "b", or "c" represents non-zero elements with respective shifting values of x, y, z, a, b, or c, x ≠ y, a≠ b, x, y, z, a, and c are positive integers, and b is a non-negative integer.

6. The method according to claim 3 or 4, wherein
m=5, and the first square matrix is: $\left[\begin{matrix}x & d & c & - 1 & - 1 \\ x & - 1 & - 1 & p & a \\ y & - 1 & c & p & - 1 \\ y & d & - 1 & - 1 & - 1 \\ - 1 & b & - 1 & - 1 & a\end{matrix}\right] ,$ wherein
"-1" represents a zero element, "x", "y", "a", "b", "c", "d", or "p" represents non-zero elements with respective shifting values of x, y, a, b, c, d, or p, x ≠ y, b≠ d, x, y, a, p, c, and d are positive integers, and b is a non-negative integer.

7. The method according to claim 3, wherein
the first square matrix comprises two columns having column weights being 4, one column having a column weight being 3, and m-3 columns having column weights being 2.

8. The method according to claim 3 or 7, wherein
m=5, and the first square matrix may be the following matrix: $\left[\begin{matrix}x & d & c & - 1 & - 1 \\ x & - 1 & - 1 & p & a \\ y & - 1 & c & p & e \\ y & d & - 1 & - 1 & a \\ - 1 & b & - 1 & - 1 & e\end{matrix}\right] ,$ wherein
"-1" represents a zero element, "x", "y", "a", "b", "c", "d", "e", or "p" represents non-zero elements with respective shifting values of x, y, a, b, c, d, e, or p, x ≠ y, b≠ d, a≠ e, x, y, a, p, c, d, and e are positive integers, and b is a non-negative integer.

9. The method according to claim 1 or 2, wherein
a column weight of each column in the first square matrix is 2 or 3, and a quantity of columns having column weights being 2 in the first square matrix is greater than 0.

10. The method according to claim 9, wherein
a quantity of columns having column weights being 2 in the first square matrix is an even number.

11. The method according to claim 9 or 10, wherein
the first square matrix is an m×m matrix, and m is a positive integer; and
the first square matrix comprises two columns having column weights being 2 and m-2 columns having column weights being 3.

12. The method according to any one of claims 9 to 11, wherein
the first square matrix is an m×m matrix, and m is an even number greater than 0; and
the first square matrix comprises m-2 columns having column weights being 2 and two columns having column weights being 3.

13. The method according to any one of claims 9 to 12, wherein
m=4, and the first square matrix is any one of the following matrices: $\left[\begin{matrix}0 & 0 & 0 & - 1 \\ 0 & x & - 1 & 0 \\ 0 & - 1 & - 1 & x \\ - 1 & 0 & - x & - 1\end{matrix}\right] , \left[\begin{matrix}0 & 0 & 0 & - 1 \\ 0 & x & - 1 & 0 \\ 0 & - 1 & - 1 & - x \\ - 1 & 0 & x & - 1\end{matrix}\right] , \left[\begin{matrix}0 & 0 & 0 & - 1 \\ 0 & - 2 x & - 1 & 0 \\ 0 & - 1 & - 1 & x \\ - 1 & 0 & x & - 1\end{matrix}\right] , \left[\begin{matrix}0 & 0 & 0 & - 1 \\ 0 & - 1 & - 1 & 0 \\ 0 & - 1 & x & - x \\ - 1 & 0 & x & - 1\end{matrix}\right] ,$ $\left[\begin{matrix}0 & 0 & 0 & - 1 \\ 0 & - 1 & - 1 & 0 \\ 0 & - 1 & x & 2 x \\ - 1 & 0 & x & - 1\end{matrix}\right] , \left[\begin{matrix}0 & 0 & 0 & - 1 \\ 0 & - 1 & - 1 & 0 \\ 0 & - 1 & x & x \\ - 1 & 0 & - x & - 1\end{matrix}\right] , \left[\begin{matrix}0 & 0 & 0 & - 1 \\ 0 & - 1 & - 1 & 0 \\ 0 & - 1 & 2 x & x \\ - 1 & 0 & x & - 1\end{matrix}\right] , \left[\begin{matrix}0 & 0 & 0 & - 1 \\ 0 & x & - 1 & 0 \\ 0 & - 1 & x & - 1 \\ - 1 & 0 & - 1 & - x\end{matrix}\right] ,$ $\left[\begin{matrix}0 & 0 & 0 & - 1 \\ 0 & x & - 1 & 0 \\ 0 & - 1 & x & - 1 \\ - 1 & 0 & - 1 & - 2 x\end{matrix}\right] , or \left[\begin{matrix}0 & 0 & 0 & - 1 \\ 0 & x & - 1 & 0 \\ 0 & - 1 & - x & - 1 \\ - 1 & 0 & - 1 & 0\end{matrix}\right] ,$ wherein
"-1" represents a zero element, "0" represents a non-zero element with a shifting value of 0, "x" represents a non-zero element with a shifting value of x, "-x" represents a non-zero element with a shifting value of Z_{c}-x, "2x" represents a non-zero element with a shifting value of 2x, "-2x" represents a non-zero element with a shifting value of Z_{c}-2x, Z_{c} is a lifting size, and x is a positive integer.

14. The method according to any one of claims 9 to 11, wherein
the first square matrix is an m×m matrix, and m is an odd number greater than 0; and
the first square matrix comprises m-3 columns having column weights being 2 and three columns having column weights being 3.

15. The method according to claim 1, 2, 9, 10, 11, or 14, wherein
m=5, and the first square matrix is any one of the following matrices: $\left[\begin{matrix}0 & 0 & 0 & - 1 & - 1 \\ 0 & - 1 & - 1 & 0 & 0 \\ 0 & - 1 & z & - z & - 1 \\ - 1 & 0 & z & - 1 & - 1 \\ - 1 & 0 & - 1 & - 1 & x\end{matrix}\right] , \left[\begin{matrix}0 & 0 & 0 & - 1 & - 1 \\ 0 & - 1 & - 1 & 0 & 0 \\ 0 & - 1 & - 1 & x & - 1 \\ - 1 & 0 & - 1 & 0 & - 1 \\ - 1 & 0 & x & - 1 & 0\end{matrix}\right] ,$ , or $\left[\begin{matrix}0 & 0 & 0 & - 1 & - 1 \\ 0 & - 1 & - 1 & 0 & 0 \\ 0 & - 1 & x & - 1 & - 1 \\ - 1 & 0 & - 1 & 0 & x \\ - 1 & 0 & - 1 & - 1 & 0\end{matrix}\right] ,$ wherein
"-1" represents a zero element, "0" represents a non-zero element with a shifting value of 0, "x" represents a non-zero element with a shifting value of x, "-x" represents a non-zero element with a shifting value of Z_{c}-x, "z" represents a non-zero element with a shifting value of z, "-z" represents a non-zero element with a shifting value of Z_{c}-z, Z_{c} is a lifting size, and x and z are positive integers.

16. The method according to claim 1 or 2, wherein
a column weight of each column and a row weight of each row in the first square matrix are both G, the first square matrix comprises a first row and a second row, a quantity of elements in an intersection between a set of column numbers of columns in which non-zero elements in the first row are located and a set of column numbers of columns in which non-zero elements in the second row are located is 2, the first row and the second row are any two rows in the first square matrix, and G is greater than or equal to 3.

17. The method according to claim 16, wherein G=3.

18. The method according to claim 17, wherein
the first square matrix comprises a first column and a second column, an intersection between a set of row numbers of rows in which non-zero elements in the first column are located and a set of row numbers of rows in which non-zero elements in the first column are located comprises a maximum of one row number, and the first column and the second column are any two columns in the first square matrix; and
row numbers of any two rows in the first square matrix belong to a set of row numbers of rows in which non-zero elements in a column in the first square matrix are located.

19. The method according to claim 17 or 18, wherein
the first square matrix is an m×m matrix, and m is a positive integer; and
non-zero elements in the first square matrix comprise first-type non-zero elements and second-type non-zero elements, wherein
positions of the first-type non-zero elements comprise: a 1^{st} column to a 3^{rd} column in a 1^{st} row, a 4^{th} column and a 5^{th} column in a 2^{nd} row, ..., and a 2t^{th} column and a (2t+1)^{th} column in a t^{th} row in the first square matrix, and a 1^{st} row to a 3^{rd} row in a 1^{st} column, a 4^{th} row and a 5^{th} row in a 2^{nd} column, ..., and a 2t^{th} row and a (2t+1)^{th} row in a t^{th} column in the first square matrix, wherein t is greater than or equal to 2; and
the second-type non-zero elements are located in a first sub-region in the first square matrix, and the first sub-region is defined by an ${\left(m-\left⌈\frac{m}{2}\right⌉+1\right)}^{th}$ row to an m^{th} row and an ${\left(m-\left⌈\frac{m}{2}\right⌉+1\right)}^{th}$ column to an m^{th} column in the first matrix region.

20. The method according to claim 19, wherein
shifting values of the first-type non-zero elements are 0.

21. The method according to claim 19 or 20, wherein
shifting values of the second-type non-zero elements are determined based on values of x₁, x₂, ..., and xₜ, x₁, x₂, ..., and xₜ are all greater than or equal to 0, and t is a positive integer.

22. The method according to claim 21, wherein
t is equal to 1, and the shifting values of the second-type non-zero elements are k₁x₁; or
t is equal to 2, and the shifting values of the second-type non-zero elements are k₁x₁, -k₁x₁, k₂x₂, -k₂x₂, or k₁x₁+k₂x₂; or
t is greater than or equal to 3, and the shifting values of the second-type non-zero elements are a linear combination of a maximum of two of x₁, x₂, ..., and xt, wherein
k₁ and k₂ are positive integers.

23. The method according to any one of claims 19 to 22, wherein
when m is an even number, the non-zero elements in the first square matrix further comprise a third-type non-zero element, and the third-type non-zero element is located in an $\frac{{m}_{th}}{2}$ row and an $\frac{{m}_{th}}{2}$ column in the first square matrix.

24. The method according to claim 23, wherein
a shifting value of the third-type non-zero element is not 0; or
a shifting value of the third-type non-zero element is determined based on values of x₁, x₂, ..., and xₜ, x₁, x₂, ..., and xₜ are all greater than or equal to 0, and t is a positive integer.

25. The method according to any one of claims 16 to 24, wherein
the first square matrix is a 4×4 matrix, and the first square matrix is any one of the following matrices: $\left[\begin{matrix}0 & 0 & 0 & - 1 \\ 0 & x & - 1 & 0 \\ 0 & - 1 & x & - x \\ - 1 & 0 & x & - 3 x\end{matrix}\right] , \left[\begin{matrix}0 & 0 & 0 & - 1 \\ 0 & x & - 1 & 0 \\ 0 & - 1 & x & - 2 x \\ - 1 & 0 & x & - 4 x\end{matrix}\right] , or \left[\begin{matrix}0 & 0 & 0 & - 1 \\ 0 & x & - 1 & 0 \\ 0 & - 1 & x & - 2 x \\ - 1 & 0 & x & - 3 x\end{matrix}\right] ,$ , wherein
"-1" represents a zero element, "0" represents a non-zero element with a shifting value of 0, "x" represents a non-zero element with a shifting value of x, "-x" represents a non-zero element with a shifting value of Z_{c}-x, "-2x" represents a non-zero element with a shifting value of Z_{c}-2x, "3x" represents a non-zero element with a shifting value of Z_{c}-3x, "-4x" represents a non-zero element with a shifting value of Z_{c}-4x, Z_{c} is a lifting size, and x is a positive integer.

26. The method according to any one of claims 16 to 24, wherein
the first square matrix is a 5×5 matrix, and the first square matrix is any one of the following matrices: $\left[\begin{matrix}0 & 0 & 0 & - 1 & - 1 \\ 0 & - 1 & - 1 & 0 & 0 \\ 0 & - 1 & x & - 2 x & - 1 \\ - 1 & 0 & - 1 & 0 & - x \\ - 1 & 0 & y & - 1 & 0\end{matrix}\right] , \left[\begin{matrix}0 & 0 & 0 & - 1 & - 1 \\ 0 & - 1 & - 1 & 0 & 0 \\ 0 & - 1 & x & - x & - 1 \\ - 1 & 0 & - 1 & 0 & x \\ - 1 & 0 & y & - 1 & 0\end{matrix}\right] , or \left[\begin{matrix}0 & 0 & 0 & - 1 & - 1 \\ 0 & - 1 & - 1 & 0 & 0 \\ 0 & - 1 & x & - x & - 1 \\ - 1 & 0 & - 1 & 0 & x \\ - 1 & 0 & y & - 1 & 0\end{matrix}\right] ,$ wherein
"-1" represents a zero element, "0" represents a non-zero element with a shifting value of 0, "x" represents a non-zero element with a shifting value of x, "-x" represents a non-zero element with a shifting value of Z_{c}-x, "-2x" represents a non-zero element with a shifting value of Z_{c}-2x, "y" represents a non-zero element with a shifting value of y, Z_{c} is a lifting size, and x and y are positive integers.

27. The method according to any one of claims 1 to 26, wherein
the first matrix region further comprises at least one second square matrix, the first square matrix does not overlap the at least one second square matrix, and a first sub-region defined by the first square matrix and the at least one second square matrix comprises all diagonal elements in the first matrix region; and
elements in the first matrix region that are in an upper right part of the first sub-region are all zero elements, and elements in the first matrix region that are in a lower left part of the first sub-region are all zero elements; or elements in the first matrix region that are in an upper right part of the first sub-region are all zero elements, and a region that is in the first matrix region and that is in a lower left part of the first sub-region comprises a non-zero element; or a region that is in the first matrix region and that is in an upper right part of the first sub-region comprises a non-zero element, and elements in the first matrix region that are in a lower left part of the first sub-region are all zero elements.

28. The method according to claim 27, wherein
the at least one second square matrix is of an upper triangular structure, a lower triangular structure, a diagonal structure, or a dual-diagonal structure; and
the first square matrix is located in an upper left corner of the first matrix region, the region that is in the first matrix region and that is in the upper right part of the first sub-region comprises the non-zero element, and the elements in the first matrix region that are in the lower left part of the first sub-region are all zero elements; or the first square matrix is located in a lower right corner of the first matrix region, the elements in the first matrix region that are in the upper right part of the first sub-region are all zero elements, and the region that is in the first matrix region and that is in the lower left part of the first sub-region comprises the non-zero element.

29. A communication apparatus, comprising a module or a unit configured to perform the method according to any one of claims 1 to 28.

30. A communication apparatus, comprising a processor and an interface circuit, wherein the interface circuit is configured to: receive a signal from a communication apparatus other than the communication apparatus and transmit the signal to the processor, or send a signal from the processor to a communication apparatus other than the communication apparatus, and the processor is configured to implement the method according to any one of claims 1 to 28 by using a logic circuit or by executing code instructions.

31. The communication apparatus according to claim 30, wherein the communication apparatus is a chip or a chip system.

32. A computer-readable storage medium, wherein the storage medium stores a computer program or instructions, and when the computer program or the instructions are executed by a communication apparatus, the method according to any one of claims 1 to 28 is implemented.

33. A computer program product, comprising a computer program, wherein when the computer program is run, the method according to any one of claims 1 to 28 is implemented.

34. A communication system, comprising:
a transmitter device configured to perform the method according to any one of claims 1 and 3 to 28; and
a receiver device configured to perform the method according to any one of claims 2 to 28.
